# EUROPEAN PATENT APPLICATION

(11) **EP 4 468 000 A1**
(43) Date of publication of application: **27.11.2024**
(21) Application number: 22921845.8
(22) Date of filing: 19.01.2022
(51) Int. Cl.: G01R 31/392

(54) **BATTERY RESIDUAL VALUE MANAGEMENT SYSTEM AND BATTERY RESIDUAL VALUE MANAGEMENT METHOD**

(71) Applicant: HITACHI HIGH-TECH CORPORATION, Tokyo 105-6409 (JP)
(72) Inventor: OZAWA Chiaki, Tokyo 105-6409 (JP); FUJIMOTO Akira, Tokyo 105-6409 (JP); FUJIMOTO Hiroya, Tokyo 105-6409 (JP)
(74) Representative: MERH-IP Matias Erny Reichl Hoffmann Patentanwälte PartG mbB
(86) International application number: PCT/JP2022/001774
(87) International publication number: WO 2023/139684

(57) **Abstract**

The disclosure discloses a technique for more accurately evaluating a residual value of a secondary battery. For this reason, the disclosure proposes a battery residual value management system that manages a residual value of a battery, the battery residual value management system including: at least one storage device configured to store information about a multi-dimensional vector space formed by at least three indexes for evaluating the residual value of the battery, the multi-dimensional vector space including a plurality of regions for determining a residual value rank of the battery, each of the regions being defined by one or more threshold values set for each index in the multi-dimensional vector space; and at least one processor configured to acquire the information about the multi-dimensional vector space from the storage device and determine, based on the at least three indexes of the battery that is a residual value assessment target, to which of the plurality of regions in the multi-dimensional vector space the battery being the residual value assessment target belongs, thereby determining the residual value rank of the battery that is the residual value assessment target (see FIG. 2A).

## Description

### Technical Field

The disclosure relates to a battery residual value management system and a battery residual value management method.

### Background Art

A secondary battery (for example, a lithium ion battery) is used in an electric automobile, and a secondary battery or a stationary battery is also used in a factory. Since such a secondary battery is degraded while being used, it is necessary to evaluate performance (presence or absence of performance degradation, and service life) of the secondary battery during or after use. A method of evaluating a residual value of the secondary battery is also considered. For example, PTL 1 discloses a technique of evaluating a residual value of a secondary battery based on a graph whose one axis is the residual value of the secondary battery and whose other axis is information about an elapsed period from a time when the secondary battery is manufactured. A correction value of a state of health (SOH: an index indicating health or a degradation state of a battery) is obtained by multiplying the SOH by an attenuation coefficient, and the graph includes residual value rank boundary display for classifying the graph into a plurality of residual value ranks according to a level of the correction value of the SOH, and group boundary display for classifying the plurality of residual value ranks into a plurality of groups indicating types of applications where the battery can be used according to the level of the correction value of the SOH.

### Citation List

### Patent Literature

PTL 1: JP2020-169871A

### Summary of Invention

### Technical Problem

However, the technique disclosed in PTL 1 cannot accurately evaluate the residual value of the secondary battery since the residual value evaluation of the secondary battery depends only on the SOH. This is because, even when the value of the SOH is high, the secondary battery may be in a degraded state due to another factor. For example, in the secondary battery, there is always a risk that a sudden abnormality occurs even when the value of the SOH is healthy. A consumer side (secondary battery user) uses a secondhand secondary battery with such a risk. For this reason, an index called an abnormal degradation level indicating a level of a risk of occurrence of a sudden abnormality is important for residual value evaluation, and such a point of view is absent in the related art represented by PTL. That is, it is not possible to appropriately evaluate a residual value of a secondary battery only by using a single index such as an SOH, which is insufficient for safely and stably reusing, repurposing, and operating a secondhand secondary battery.

In view of such a situation, the disclosure proposes a technique for more accurately evaluating a residual value of a secondary battery.

### Solution to Problem

In order to solve the above problem, the disclosure proposes a battery residual value management system that manages a residual value of a battery, the battery residual value management system including: at least one storage device configured to store information about a multi-dimensional vector space formed by at least three indexes for evaluating the residual value of the battery, the multi-dimensional vector space including a plurality of regions for determining a residual value rank of the battery, each of the regions being defined by one or more threshold values set for each index in the multi-dimensional vector space; and at least one processor configured to acquire the information about the multi-dimensional vector space from the storage device and determine, based on the at least three indexes of the battery that is a residual value assessment target, to which of the plurality of regions in the multi-dimensional vector space the battery being the residual value assessment target belongs, thereby determining the residual value rank of the battery that is the residual value assessment target.

Additional features related to the disclosure will become apparent from the description of the specification and the accompanying drawings. Aspects of the disclosure may be achieved and implemented using elements, combinations of various elements, the following detailed description, and accompanying claims.

The description of the specification is merely a typical example, and does not limit the scope of the claims or application examples of the disclosure in any sense.

### Advantageous Effects of Invention

According to the technique of the disclosure, it is possible to accurately evaluate a residual value of a secondary battery.

### Brief Description of Drawings

FIG. 1 shows a schematic configuration example of an entire battery residual value management system 100 according to an embodiment.
FIG. 2A shows an example of a three-dimensional evaluation region (division) according to the embodiment.
FIG. 2B shows a relationship (example) between a residual value rank and ranges of respective indexes (SOH, IR, and abnormal degradation level).
FIG. 2C shows each measurement index value of a type (model name) of each battery to be diagnosed (diagnosed battery) and a residual value rank (example) that is an evaluation result corresponding thereto.
FIG. 3A shows a schematic configuration example 1 of a battery residual value assessment system 101 according to the embodiment.
FIG. 3B shows a schematic configuration example 2 of the battery residual value assessment system 101 using a cloud server.
FIG. 3C shows a schematic configuration example 3 of the battery residual value assessment system 101 according to an on-premises form.
FIG. 3D shows a configuration example 4 of the battery residual value assessment system 101 according to an edge computing form.
FIG. 4 shows an overview of a residual value matching function.
FIG. 5 shows an example of a residual value matching result.
FIG. 6 shows a schematic configuration example of the battery residual value assessment system 101 including a residual value matching apparatus according to the embodiment.
FIG. 7A shows an overview of a battery residual value assessment calibration function according to the embodiment (before calibration).
FIG. 7B shows an overview of the battery residual value assessment calibration function according to the embodiment (after calibration).
FIG. 8 shows a schematic configuration example of the battery residual value assessment system 101 including a battery residual value assessment calibration apparatus according to the embodiment.
FIG. 9A shows an overview of a battery residual value correction function according to the embodiment and shows a threshold value before correction (example).
FIG. 9B shows an overview of the battery residual value correction function according to the embodiment and shows a threshold value after correction (example).
FIG. 10 shows a schematic configuration example of the battery residual value assessment system 101 including a battery residual value correction apparatus according to the embodiment.
FIG. 11A shows an overall schematic configuration example 1 of the battery residual value management system 100 including a battery-residual-value-corresponding supply chain system 102 according to the embodiment.
FIG. 11B shows an example of a generated residual-value-based demand plan (short-term, medium-term, and long-term reservation information).
FIG. 12A shows an overall schematic configuration example 2 of the battery residual value management system 100 including the battery-residual-value-corresponding supply chain system 102 according to the embodiment.
FIG. 12B shows an example of a generated residual-value-based procurement plan (short-term, medium-term, and long-term reservation information).
FIG. 13A shows an overall schematic configuration example 3 of the battery residual value management system 100 including the battery-residual-value-corresponding supply chain system 102 according to the embodiment.
FIG. 13B shows a configuration example of a residual-value-based battery demand-supply conformity determination result.
FIG. 14A shows an overall schematic configuration example 4 of the battery residual value management system 100 including the battery-residual-value-corresponding supply chain system 102 according to the embodiment.
FIG. 14B shows a display example of a surplus or shortage quantity predicted for the future based on a result of future supply prediction and demand prediction.
FIG. 14C shows a concept of surplus-shortage prediction.
FIG. 15A shows an overall schematic configuration example 5 of the battery residual value management system 100 including the battery-residual-value-corresponding supply chain system 102 according to the embodiment.
FIG. 15B shows a battery provision adjustment result based on future prediction data.
FIG. 16A shows an overall schematic configuration example 1 of the battery residual value management system 100 including a battery-residual-value-corresponding maintenance management system 103 according to the embodiment.
FIG. 16B shows a guarantee service content (upper table) corresponding to an abnormal degradation level of a battery and a guarantee service provision result (lower table) determined for each battery.
FIG. 17A shows an overall schematic configuration example 2 of the battery residual value management system 100 including the battery-residual-value-corresponding maintenance management system 103 according to the embodiment.
FIG. 17B shows a degradation monitoring service content (upper table) corresponding to an abnormal degradation level of a battery and a guarantee service provision result (lower table) determined for each battery.
FIG. 18A shows an overall schematic configuration example 3 of the battery residual value management system 100 including the battery-residual-value-corresponding maintenance management system 103 according to the embodiment.
FIG. 18B shows a state in which a threshold value calibrated by the battery residual value assessment calibration function is reflected in determination of the guarantee service content and the degradation monitoring service content.
FIG. 19 shows a schematic configuration example of the battery residual value management system 100 according to a modification.

### Description of Embodiments

Hereinafter, embodiments of the disclosure will be described with reference to the accompanying drawings. In the accompanying drawings, functionally identical elements may be denoted by the same number. The accompanying drawings show specific embodiments and implementation examples according to the principle of the disclosure, but the embodiments and the implementation examples are provided for understanding the disclosure and are not to be used for limitedly interpreting the disclosure in any way.

Embodiments are described in sufficient details for those skilled in the art to implement the disclosure, but it should be understood that other implementations and aspects are possible, and changes in configurations and structures and replacement of various elements are possible without departing from the scope and spirit of the technical idea of the disclosure. Therefore, the following description is not to be construed as being limited thereto.

### <Overall Configuration Example of System>

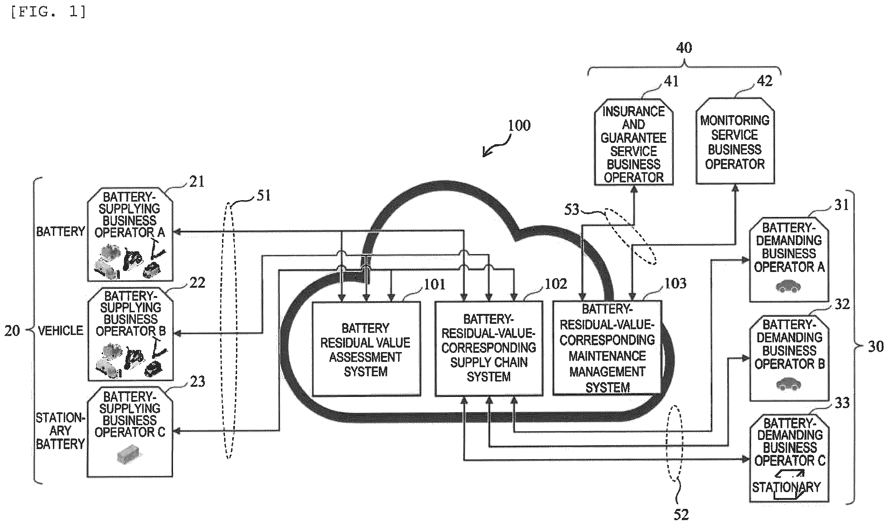

FIG. 1 shows a schematic configuration example of an entire battery residual value management system 100 according to an embodiment.

The battery residual value management system 100 includes, for example, in a cloud, a battery residual value assessment system 101 that evaluates (assesses) a residual value of a secondary battery (hereinafter, also simply referred to as a "battery"), a battery-residual-value-corresponding supply chain system 102 that manages supply of the secondary battery whose residual value is evaluated, and a battery-residual-value-corresponding maintenance management system 103 that manages an insurance and guarantee service and a monitoring service of the secondary battery to be supplied, and is connected, via networks 51 to 53, to a battery-supplying business operator computer group 20, a battery-demanding business operator computer group 30, and a service business operator computer group 40. However, not all of the battery residual value assessment system 101, the battery-residual-value-corresponding supply chain system 102, and the battery-residual-value-corresponding maintenance management system 103 are necessarily provided to establish the battery residual value management system 100. For example, the battery residual value management system 100 is established as long as the battery residual value assessment system 101 is provided. That is, for example, it is conceivable that the battery residual value management system 100 is formed by only the battery residual value assessment system 101, the battery residual value assessment system 101 + the battery-residual-value-corresponding supply chain system 102, or the battery residual value assessment system 101 + the battery-residual-value-corresponding supply chain system 102 + the battery-residual-value-corresponding maintenance management system 103.

In the battery residual value management system 100, the battery-supplying business operator computer group 20 is connected to the battery residual value assessment system 101 and the battery-residual-value-corresponding supply chain system 102. The battery-demanding business operator computer group 30 is connected to the battery-residual-value-corresponding supply chain system 102, and the service business operator computer group 40 is connected to the battery-residual-value-corresponding maintenance management system 103.

The battery residual value assessment system 101, the battery-residual-value-corresponding supply chain system 102, and the battery-residual-value-corresponding maintenance management system 103 may be implemented by one server computer. These internal systems 101 to 103 may be configured to be connected to a computer of at least one type of business operator (for example, a battery-supplying business operator) without a network (on-premises), and these internal systems 101 to 103 may be configured to be disposed (or distributed) near a battery business operator (for example, a battery regeneration business operator) and store only a calculation result in the cloud (edge computing).

The battery residual value assessment system 101 can process data of a secondary battery uploaded by accessing the cloud (an example) from the battery-supplying business operator computer group 20 and thus assess a residual value of the battery. The battery-residual-value-corresponding supply chain system 102 acquires data from the battery-supplying business operator computer group 20 and the battery-demanding business operator computer group 30, and optimizes battery demand and supply. The battery-residual-value-corresponding maintenance management system 103 provides data to be used when an insurance and guarantee service business operator and a monitoring service business operator maintain and monitor the battery.

### <Battery Residual Value Assessment System>

### (i) Secondary Battery Residual Value Evaluation Element

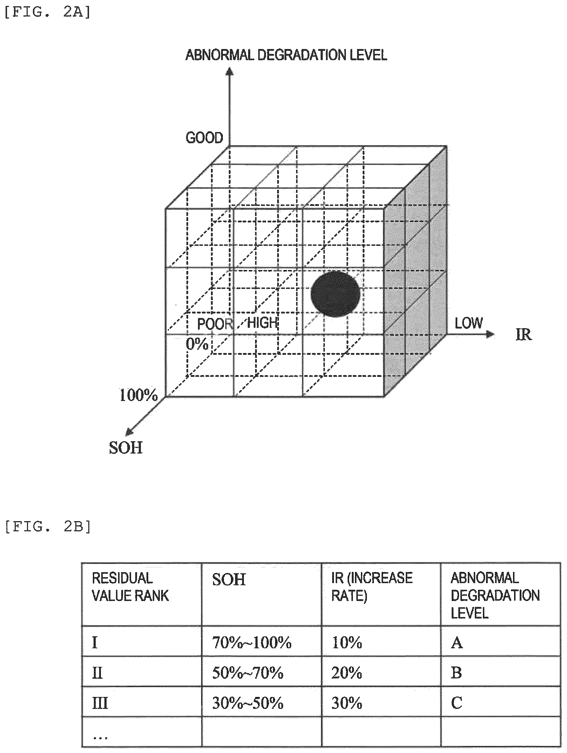

FIGS. 2A to 2C show examples of battery residual value evaluation elements according to the embodiment. In the battery residual value assessment system 101 according to the embodiment, in addition to a state of health (SOH: capacity), two indexes, for example, internal resistance (IR) and an abnormal degradation level are introduced, and a residual value of a secondary battery is assessed (evaluated) by a combination of these indexes.

### (i-1) Regarding Three-Dimensional Evaluation Region (Division): FIG. 2A

FIG. 2A shows an example of a three-dimensional evaluation region (division) according to the embodiment. As shown in FIG. 2A, in the embodiment, three factors (indexes) of an SOH (from 0 to 100%), IR (an evaluation by an internal resistance value or an increase rate), and an abnormal degradation level (from poor to good) are introduced, and residual value evaluation is performed by a plurality of spatial regions defined by ranges of respective index values in a three-dimensional space having the three indexes as axes (to determine a residual value rank). That is, a degradation state of the secondary battery is defined in a three-dimensional spatial region formed by combining a region defined on a two-index (two-dimensional) map of the SOH and the IR with the abnormal degradation level that is a third index (battery residual value assessment apparatus). One or more threshold values are set for each index, and the secondary battery is ranked according to the degradation state of the battery for each index.

In FIG. 2A, a three-dimensional space (three-dimensional vector space) including the three indexes is introduced, and the region is defined therein, but being three-dimensional is an example. The number of indexes may be three or more, and a threshold value may be set for each index to define a region in a multi-dimensional vector space, and the residual value rank may be determined according to the degradation state of each secondary battery.

### (i-2) Regarding Residual Value Rank Threshold Value Setting: FIG. 2B

FIG. 2B shows a relationship (example) between the residual value rank and ranges of the respective indexes (SOH, IR, and abnormal degradation level). First, for the SOH, a threshold value of an SOH value of the secondary battery is set, and a region is determined. For example, a case where the SOH value is 70% or more and less than 100% can be set into an SOH first region (rank I), a case where the SOH value is 50% or more and less than 70% can be set into an SOH second region (rank II), a case where the SOH value is 30% or more and less than 50% can be set into an SOH third region (rank III), and so on. Here, an SOH of 70%, which is generally guaranteed for an electric automobile, can be set as a first threshold value, and an SOH of 50%, which enables an operation as an electric automobile in a limited operational spatial region for practical use (for example, limited within a factory or factory site) can be set as a second threshold value. In addition, an SOH of 30% at which charging efficiency is generally low and a reuse effect is low even in stationary use can be set as a third threshold value.

For the IR, a threshold value of the IR is set by an internal resistance increase rate from a design value (initial value) of the secondary battery, and a region is determined. This is because a designed resistance value differs depending on each secondary battery. For example, a case where the internal resistance value increase rate is less than 10% with respect to the initial value can be set into an IR first region (rank I), a case where the internal resistance value increase rate is 10% or more and less than 20% can be set into an IR second region (rank II), a case where the internal resistance value increase rate is 20% or more and less than 30% can be set into an IR third region (rank III), and so on.

For specific diagnosis (estimation) of the SOH and the IR, for example, a DC cut-off method can be used. According to the DC cut-off method, in a pause period after an end of discharging or a pause period after an end of charging, the IR is estimated using a voltage variation ΔVa in a first period ta, and the SoH is estimated using a voltage variation ΔVb in a second period tb. Accordingly, the IR and the SoH can both be estimated in a shorter time than in the related art. A relationship table used in the DC cut-off method describes an internal resistance parameter that defines a function f_{IR} representing a relationship between the IR and ΔVa. The internal resistance parameter includes c_IR_I that varies depending on an output current of the battery and c_IR_T that varies depending on a temperature of the battery. Accordingly, even when the function f_{IR} varies depending on the temperature of the battery or the output current of the battery, the IR can be accurately estimated. The same applies to a degradation state parameter that defines a function f_{SOH}. The relationship table describes the internal resistance parameter and the degradation state parameter for each of the pause period after charging and the pause period after discharging. Accordingly, even when the function (that is, a characteristic of the battery) differs between the pause period after charging and the pause period after discharging, the IR and the SOH can be accurately estimated. Specifically, the IR and the SOH are calculated (estimated) according to the following equations (1) and (2). Ri = fRi(ΔVa, c_Ri_T_1, c_Ri_T_2, ..., c_Ri_I_1, c_Ri_I_2, ...) SOH = fSOH(ΔVb, c_SOH_T_1, c_SOH_T_2, ..., c_SOH_I_1, c_SOH_I_2, ...)

For the abnormal degradation level, similarly to the SOH and the IR, a threshold value is set by the number of abnormalities detected in the secondary battery, and a region is determined. For the abnormal degradation level, it is conceivable to discriminate the abnormal degradation level by an abnormal slope or abnormal variation of a recovery voltage during a minute change time according to the DC cut-off method. Specifically, in the discrimination of the abnormal degradation level based on the abnormal slope of the recovery voltage during the minute change time according to the DC cut-off method, a ratio of a voltage difference ΔVa in a first period to a voltage difference ΔVb in a second period is calculated, and if the ratio is equal to or larger than a threshold value ΔVa_lim, it is estimated that there is a failure in the battery. Accordingly, for example, it is possible to estimate whether the battery is in a normal state without preparing equipment used for impedance measurement or the like. A relationship between ΔVa_lim and ΔVb can be defined for each value of Δt. Accordingly, actual measured values of ΔVa and ΔVb can be obtained at relatively free timing. A function representing the relationship between ΔVb and ΔVa_lim may change according to at least one of a temperature T of the battery, a discharge current I of the battery; and a discharge end voltage V of the battery. In this case, a function parameter may be defined in advance for each value of T, for each value of I, and for each value of V, and ΔVa_lim may be calculated using the function parameter corresponding to actual measured values thereof. Therefore, a function f representing the relationship between ΔVb and ΔVa_lim in this case is defined as the following equation (3). ΔVa_lim = f(ΔVb, c_Rn_T_1, c_Rn_T_2, ..., c_Rn_I_1, c_Rn_I_2, ..., c_Rn_V_1, c_Rn_V_2,...)

Since Va_lim is a function of ΔVb, the function f includes ΔVb as an argument. The function f further includes one or more parameters c_Rn_T that change according to the temperature T. One or more parameters c_Rn_I that change according to the current I, and one or more parameters c_Rn_V that change according to the voltage V, are provided similarly.

In the discrimination of the abnormal degradation level by the abnormal variation of the recovery voltage during the minute change time according to the DC cut-off method, if the voltage variation (standard deviation σ) in a third period is equal to or larger than a threshold value σ_lim, it is estimated that there is a failure in the battery. Accordingly, similarly to the discrimination of the abnormal degradation level based on the abnormal slope, it is possible to estimate whether the battery is in a normal state without preparing equipment used for impedance measurement, for example.

A case where one of the above-described abnormalities is detected may be defined as a first threshold value, a case where two of the above-described abnormalities are detected may be defined as a second threshold value, and a case where a deviation from the threshold value of the abnormal degradation level is large may be defined as a third threshold value. For example, an abnormal degradation level A (rank I) can be set when no abnormality is detected, an abnormal degradation level B (rank II) can be set when one abnormality is detected, an abnormal degradation level C (rank III) can be set when two abnormalities are detected, and so on. Such threshold value setting is an example, and the threshold value may be set in a different manner.

Based on the three indexes defined as described above, ranking is performed according to the degradation state of the battery. When there are K types of threshold value setting of the SOH, L types of threshold value setting of the IR, and M types of threshold value setting of the abnormal degradation level, K × L × M regions are set in the three-dimensional space in FIG. 2A, and the residual value rank is allocated to each region. Different residual value ranks may be allocated to all of the K × L × M regions, or the same residual value rank may be allocated to a plurality of regions.

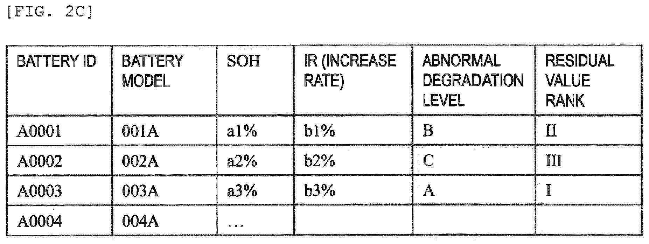

### (i-3) Diagnosis Result Example: FIG. 2C

FIG. 2C shows each measurement index value of a type (model name) of each battery to be diagnosed (diagnosed battery) and a residual value rank (example) that is an evaluation result corresponding thereto.

The battery residual value assessment system 101 can be configured to store residual value ranks (for example, a table) corresponding to combinations of ranks (K × L × M combinations) of the three indexes in a storage unit (storage device) to be described later and acquire (determine) the residual value rank corresponding to a combination of ranks of the SOH, the IR, and the abnormal degradation level of the secondary battery to be diagnosed (evaluated). FIG. 2C shows the residual value rank of each secondary battery obtained in this manner.

In FIG. 2C, a determination (assessment) result of the secondary battery can be formed by, for example, a battery ID for uniquely specifying and identifying the secondary battery, a battery model indicating a type of the secondary battery, an SOH value, an IR value, and an abnormal degradation level of the secondary battery obtained by measurement, and information about the determined residual value rank.

As described above, in the embodiment, by introducing the IR value and the abnormal degradation level in addition to the SOH value as indexes and evaluating the residual value in the three-dimensional space, the residual value of the secondary battery can be accurately assessed (evaluated) as compared to the related art. For example, even when the SOH value is high, the abnormal degradation level may be poor, and in such a case, a secondary battery provider can present to a purchaser in advance that there is a possibility that a sudden abnormality occurs.

### (ii) Configuration Example of Battery Residual Value Assessment System 101

### (ii-1) Basic Configuration Example: Configuration Example Implemented Using Cloud Server

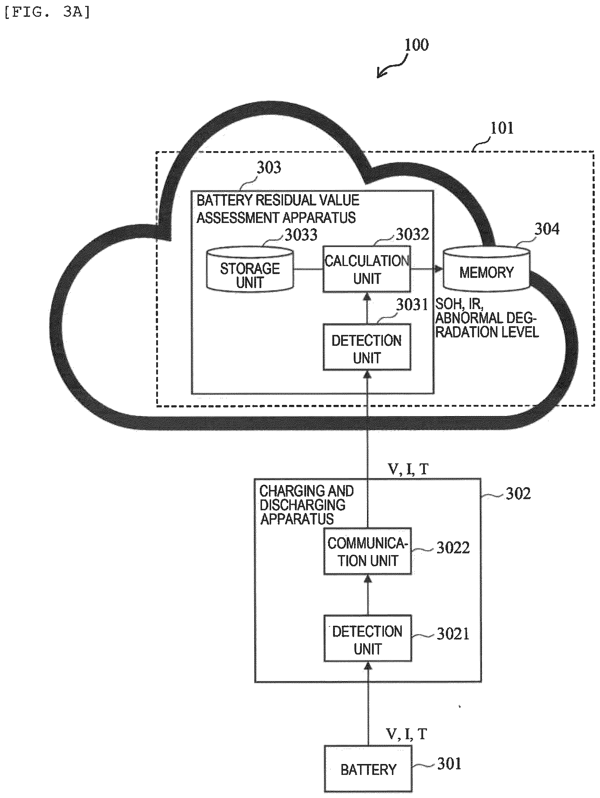

FIG. 3A shows a schematic configuration example 1 of the battery residual value assessment system 101 according to the embodiment. The battery residual value assessment system 101 includes a battery residual value assessment apparatus 303 that acquires, via a network (for example, the Internet), a measurement result from a charging and discharging apparatus (may be a tester) 302, which is a dedicated apparatus for measuring a battery (secondary battery) 301 and evaluates (assesses) a residual value of the battery 301, and a memory 304 that temporarily stores an evaluation result in order to display the evaluation result on a display screen and/or transmit information about the evaluation result to a user.

The charging and discharging apparatus 302 includes a detection unit 3021 that measures a voltage value V, a current value I, and a temperature T of the battery 301, and a communication unit (communication device) 3022 that transmits measured data to the battery residual value assessment apparatus 303 via a network and receives the evaluation result from the battery residual value assessment apparatus 303. In addition, a processor (CPU) that controls operations of the detection unit 3021 and the communication unit 3022 may be provided.

The battery residual value assessment apparatus 303 can be implemented by a computer, and includes a detection unit 3031, a calculation unit (processor) 3032, and a storage unit 3033. The detection unit 3031 can be implemented by a communication device, for example, and receives data transmitted from the charging and discharging apparatus 302. The calculation unit 3032 calculates the SOH value, the IR value, and the abnormal degradation level based on information about the voltage value V, the current value I, and the temperature T of the battery 301, and determines the residual value rank (FIGS. 2A and 2B) based on a combination thereof. The calculation unit 3032 stores information about the calculated SOH value, the calculated IR value, the calculated abnormal degradation level, and the determined residual value rank in the storage unit 3033 and also in the memory 304. The memory 304 may be provided inside the battery residual value assessment apparatus 303.

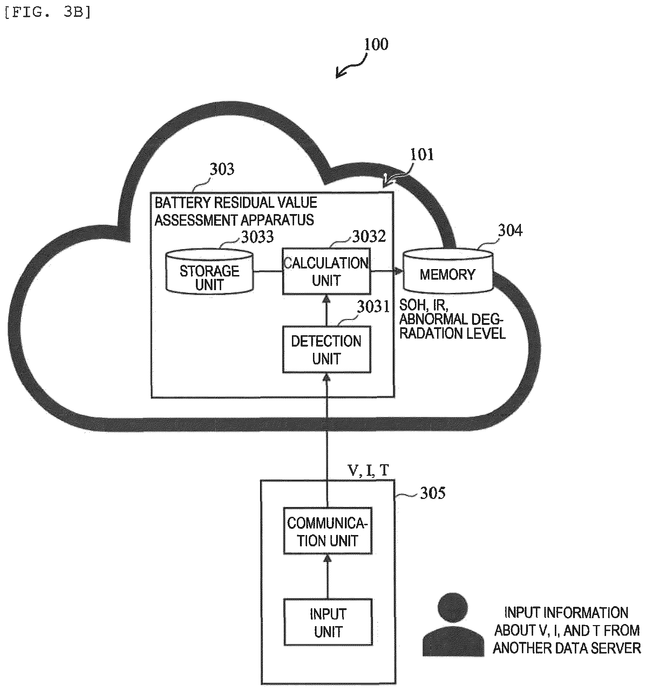

FIG. 3B shows a schematic configuration example 2 of the battery residual value assessment system 101 using a cloud server as in FIG. 3A. The configuration in FIG. 3B is different from the configuration in FIG. 3A in that, instead of using the charging and discharging apparatus 302, a computer (example) 305 is used, to which the voltage value V, the current value I, and the temperature T of the battery 301 measured by the user by using a charging and discharging apparatus (not shown) having no communication function is input. The user does not necessarily need to actually measure the battery 301, and information about the voltage value V, the current value I, and the temperature T measured in advance for the target battery 301 may be acquired from another data server (not shown) and transmitted to the battery residual value assessment apparatus 303 using the computer 305.

### (ii-2) Modification: Configuration Example Using No Cloud Server

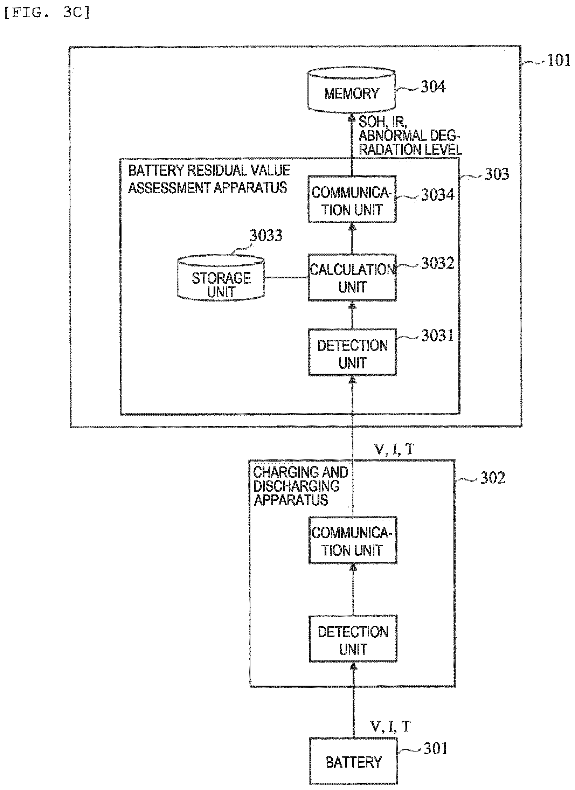

FIG. 3C shows a configuration example 3 of the battery residual value assessment system 101 according to an on-premises form. The battery residual value assessment system 101 according to the on-premises form has the same components and functions as those of the system according to the cloud server form except for a communication unit 3034. The battery residual value assessment apparatus 303 is configured to be directly connected to the charging and discharging apparatus 302 without a network. The communication unit (which can be implemented by a communication device) 3034 transmits a calculation result (SOH value, IR value, and abnormal degradation level) and an evaluation result (residual value rank) to the memory 304 via a communication line and stores the calculation result and the evaluation result therein. When the battery residual value assessment apparatus 303 and the memory 304 are not connected via the communication line, the communication unit 3034 is not necessary, and the calculation result and the evaluation result are directly stored in the memory 304 from the calculation unit 3032.

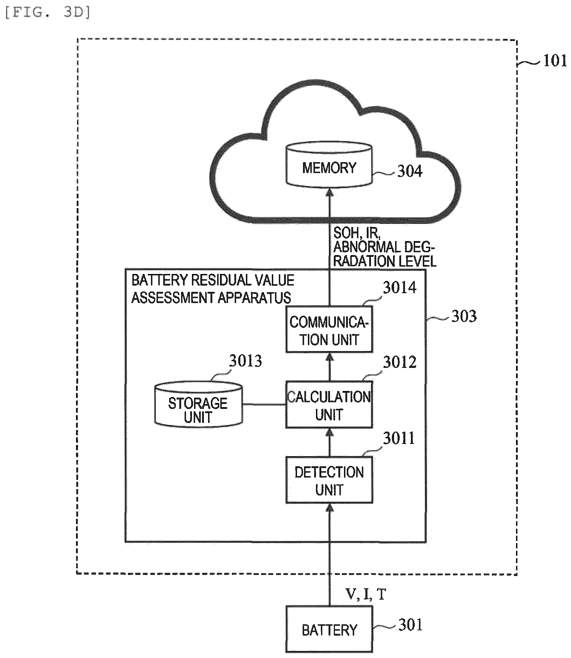

FIG. 3D shows a configuration example 4 of the battery residual value assessment system 101 according to an edge computing form. The battery residual value assessment system 101 according to the edge computing form includes the battery 301, the memory 304 in a cloud, and the battery residual value assessment apparatus 303 directly connected to the battery 301 and connected to the memory 304 in the cloud via a network. The battery residual value assessment apparatus 303 is an apparatus that receives power supply from the directly-connected battery 301, and may be integrated with a charging and discharging apparatus, a tester, or the like. The battery residual value assessment apparatus 303 includes the detection unit 3031, the calculation unit 3032, the storage unit 3033, and the communication unit 3034. The detection unit 3031 acquires the voltage V, the current I, and the temperature T of the battery 301. Such measured values may be detected by the battery 301 and notified of to the detection unit 3031, or may be acquired by the detection unit 3031 measuring the battery 301. The functions of the calculation unit 3032 and the storage unit 3033 are as described above. The communication unit 3034 can transmit the degradation state calculated by the calculation unit 3032 to the outside of the battery residual value assessment apparatus 303 (a memory 394 provided in a cloud system).

In the edge computing form, the battery residual value assessment system 101 may be implemented by incorporating an algorithm for a battery residual value assessment into a measuring device such as the charging and discharging apparatus 302, a tester, or an oscilloscope.

### (iii) Residual Value Matching Apparatus

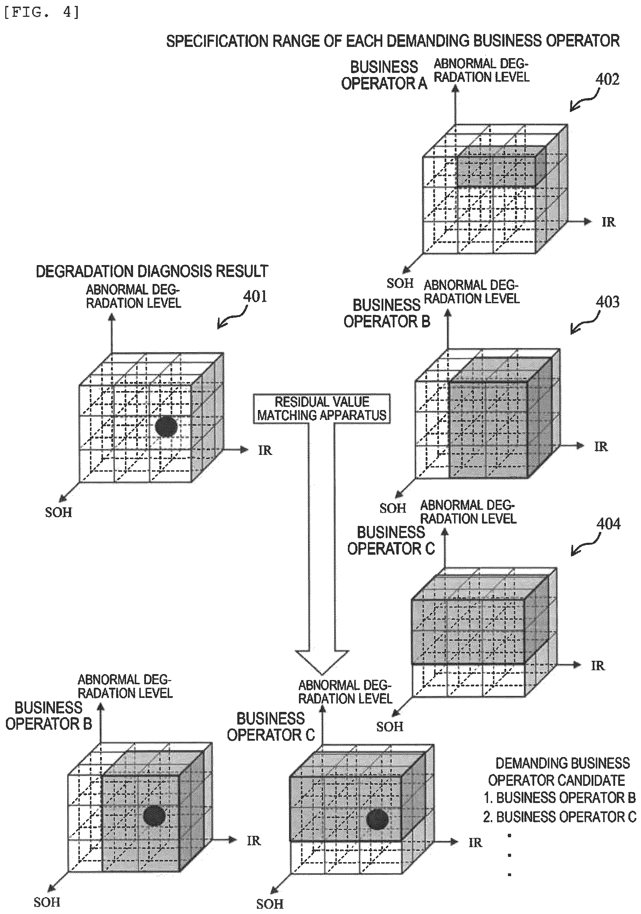

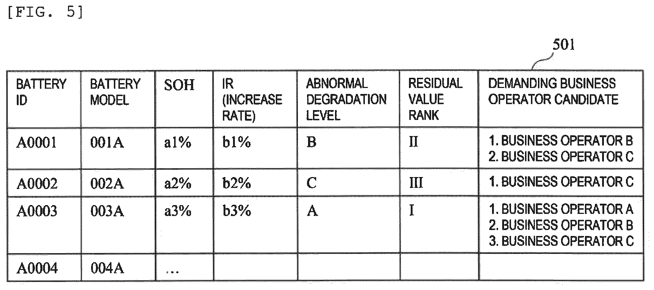

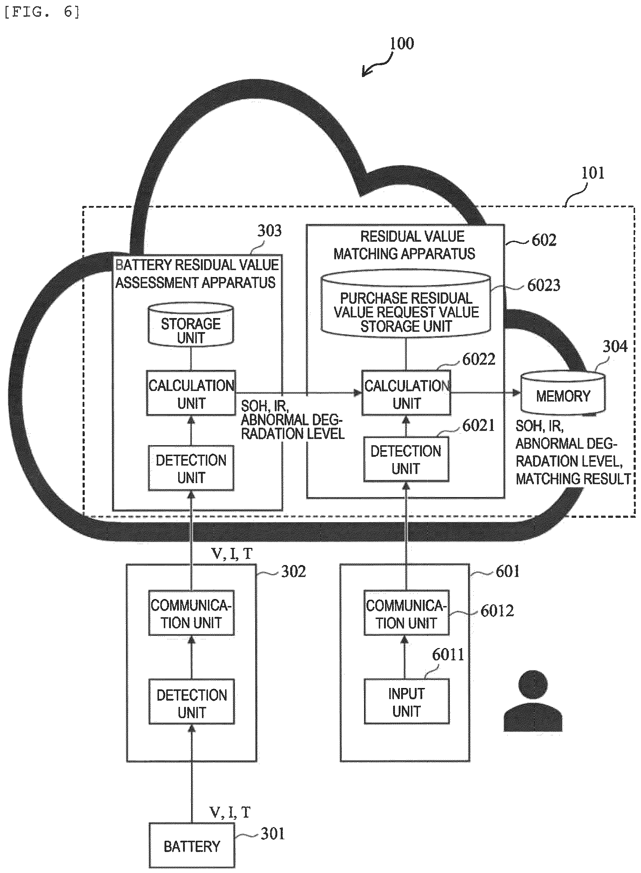

A residual value matching apparatus has a residual value matching function of matching a residual-value-evaluated battery defined in the three-dimensional spatial region in FIG. 2A with a purchase residual value requirement (purchase residual value request value storage unit) of a demanding business operator. Hereinafter, an overview of the residual value matching function (FIG. 4), a residual value matching result (FIG. 5), and a configuration example of the battery residual value assessment system 101 including the residual value matching apparatus (FIG. 6) will be sequentially described.

### (iii-1) Overview of Residual Value Matching Function: See FIG. 4

FIG. 4 shows the overview of the residual value matching function. The residual value matching function is a function of matching a battery (secondary battery) whose degradation state is diagnosed according to the three indexes defined (calculated) by the battery residual value assessment apparatus 303 with a battery matching a specification range required by each business operator.

A battery degradation state permitted or required by each business operator differs greatly. For example, for a business operator A assuming secondary use in an electric automobile, a battery in which the SOH is kept high (for example, 70% or more), the IR is close to a design value (for example, an increase in internal resistance is within 30% from a design value), and the abnormal degradation level is good (for example, A) is required (see a specification range 402 of the business operator A). Meanwhile, for a business operator B assuming an operation in a limited spatial region such as an electric forklift that travels in a factory, the SOH is allowed to a range more relaxed than that of the electric automobile (for example, 50% or more), and the abnormal degradation level is also allowed to a range (for example, D or more) including a poor region (see a specification range 403 of the business operator B). For a business operator C assuming secondary use in a stationary battery, it is conceivable that the IR is allowed to reach a region greatly increased from a design value (for example, an increase within 100% from the design value), and the abnormal degradation level is within an allowable range up to a medium degree (for example, B or C) (see a specification range 404 of the business operator C). However, the above-described customer requirement specification range is an example, and the disclosure is not limited thereto.

Accordingly, as a result of residual value matching processing, a secondary battery ranked in a region of a degradation diagnosis result 401 in FIG. 4 does not match the specification range 402 of the business operator A but matches the specification ranges 403 and 404 of the business operators B and C, and thus the business operators B and C can be selected as supply destination candidates.

### (iii-2) Residual Value Matching Result

FIG. 5 shows an example of the residual value matching result. The residual value matching result is formed by adding, to a residual value diagnosis result shown in FIG. 1C, a demanding business operator candidate 501 of a target battery derived by residual value matching. In FIG. 5, for example, since a battery with a battery ID of A0001 conforms to the specification ranges of the business operators B and C, a battery with a battery ID of A0002 conforms to only the specification range of the business operator C, and a battery with a battery ID of A0003 conforms to the specification ranges of the business operators A, B, and C, these business operators are selected as candidates for demanding business operators (provision destination). In this way, by the residual value matching function, it is possible to present a customer business operator candidate that can be provided to each battery whose degradation state is diagnosed.

### (iii-3) Configuration Example of Battery Residual Value Assessment System 101 Including Residual Value Matching Apparatus

FIG. 6 shows a schematic configuration example of the battery residual value assessment system 101 including the residual value matching apparatus according to the embodiment. In FIG. 6, the battery residual value assessment apparatus 303 and a residual value matching apparatus 602 are shown as a cloud server, and may alternatively be implemented in the on-premises form or the edge computing form.

The battery residual value assessment system 101 includes, in addition to the battery residual value assessment apparatus 303 and the memory 304, the residual value matching apparatus 602 that is connected to at least one business operator computer 601 via a network and is provided in a cloud.

The business operator computer 601 includes an input unit (which may include a keyboard, a mouse, or the like) 6011 for inputting a customer requirement specification for a battery (secondary battery) of the business operator, and a communication unit (communication device) 6012 for transmitting customer requirement specification information to the residual value matching apparatus 602 via a network.

The residual value matching apparatus 602 includes a detection unit (which may include a communication device) 6021 that receives the customer requirement specification information transmitted from the business operator computer 601, a calculation unit (which may include a processor) 6022, and a purchase residual value request value storage unit (which may include a storage device) 6023. The calculation unit 6022 acquires information (SOH value, IR value, abnormal degradation level, and residual value rank) about the degradation state of each battery generated by the battery residual value assessment apparatus 303, matches the information with the customer requirement specification information, determines a secondary battery conforming to the customer requirement specification, and extracts a demanding business operator candidate for each battery. The calculation unit 6022 stores the received customer requirement specification information and the generated residual value matching result (see FIG. 5) in the purchase residual value request value storage unit 6023, and also stores the information about the degradation state and the residual value matching result in the memory 304.

The battery residual value assessment apparatus 303 and the residual value matching apparatus 602 may be integrated as one apparatus (for example, may be implemented on one server computer).

### (iv) Battery Residual Value Assessment Calibration Apparatus

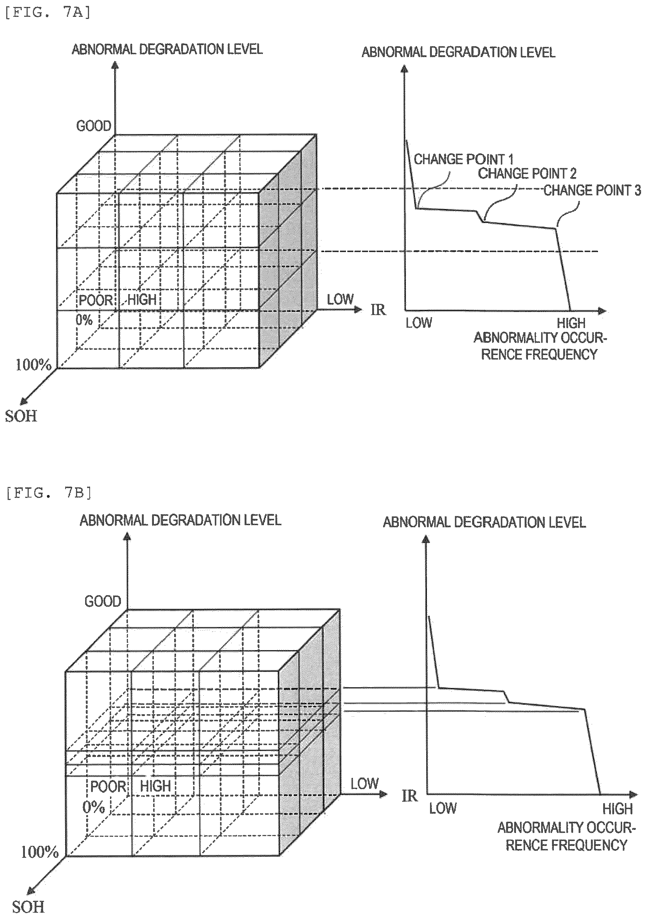

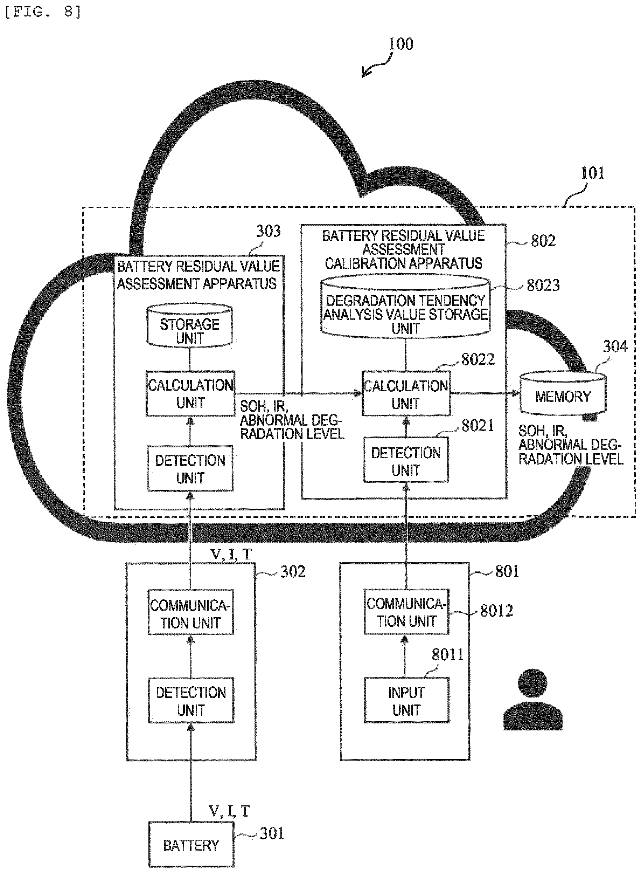

A battery residual value assessment calibration apparatus provides a function of calibrating a residual value assessment threshold value in consideration of a degradation tendency analysis value (battery degradation database for each business form and each battery actual operating state) in an actual operating state in the market with respect to a residual-value-assessed battery defined in the three-dimensional spatial region in FIG. 2A. Hereinafter, an overview of the battery residual value assessment calibration function (FIGS. 7A and 7B) and a configuration example of the battery residual value assessment system 101 including the battery residual value assessment calibration apparatus (FIG. 8) will be sequentially described.

### (iv-1) Overview of Battery Residual Value Assessment Calibration Function: See FIGS. 7A and 7B

FIGS. 7A and 7B show the overview of the battery residual value assessment calibration function according to the embodiment. As described with reference to FIGS. 2A to 2C, in the battery residual value assessment system 101, ranking (ranking based on the residual value) is performed according to the degradation state of the battery by using the three indexes of the SOH, the IR, and the abnormal degradation level. The threshold value set for each index (for example, A is a highest rank as the abnormal degradation level when the abnormal degradation level is from C to A) is set according to a design specification, the customer requirement specification of each business operator, or the like. However, there may be a difference between the setting of the threshold value and occurrence frequency of a battery abnormality or failure occurring in the market. Therefore, in order to correct such a difference, a battery residual value assessment calibration apparatus 802 provides a function of calibrating each threshold value by the degradation tendency analysis value in the actual operating state in the market.

For example, taking the abnormal degradation level as an example, when an abnormality occurring in the market is represented with abnormality occurrence frequency on a horizontal axis and the abnormal degradation level on a vertical axis, it is assumed that there are acute change points 1 to 3 of the abnormality occurrence frequency within a certain threshold value range of the abnormal degradation level as shown in FIG. 7A. In this case, a battery having an abnormal degradation level that is less likely to cause an abnormality in practice and a battery having an abnormal degradation level that is highly likely to cause an abnormality are mixed within the same threshold value.

However, in this case, when a current threshold value (for example, a temporary threshold value set first: a threshold value indicated by a dotted line in FIG. 7A) is continuously used, the abnormal degradation level of the battery and the occurrence frequency of the abnormality or failure of the battery in the market cannot be correctly evaluated since the change points 1 to 3 are not considered.

Therefore, as shown in FIG. 7B, the threshold value is calibrated according to the acute change points 1 to 3 of the abnormality occurrence frequency, and a new threshold value (a threshold value indicated by a solid line in FIG. 7B) is used for a subsequent battery residual value assessment, whereby a battery residual value evaluation can be appropriately performed. When such a new threshold value is used, for example, there is an imbalance in sizes of the regions (the above-described K × L × M regions) for rank allocation, which are set relatively equally in FIG. 2A (see a change from FIG. 7A to FIG. 7B). For example, in FIG. 7B, when the index is the abnormal degradation level, regions determined as the abnormal degradation level A (good) and the abnormal degradation level C (poor) are large, and a region determined as the abnormal degradation level B (intermediate degree) can be narrow (for example, the region determined as B is set as B1 (an upper portion in the middle) and B2 (a lower portion in the middle)).

### (iv-2) Configuration Example of Battery Residual Value Assessment System 101 Including Battery Residual Value Assessment Calibration Apparatus 802

FIG. 8 shows a schematic configuration example of the battery residual value assessment system 101 including the battery residual value assessment calibration apparatus 802 according to the embodiment. In FIG. 8, the battery residual value assessment apparatus 303 and the battery residual value assessment calibration apparatus 802 are shown as a cloud server, and may alternatively be implemented in the on-premises form or the edge computing form.

The battery residual value assessment system 101 includes, in addition to the battery residual value assessment apparatus 303 and the memory 304, the battery residual value assessment calibration apparatus 802 that is connected to at least one business operator computer 801 via a network and is provided in a cloud.

The business operator computer (for example, corresponding to any one battery-demanding business operator computer group 30) 801 includes an input unit (which may include a keyboard, a mouse, or the like) 8011 for inputting the degradation tendency analysis value (for example, information obtained from a battery degradation database for each business form and each battery actual operating state) in the actual operating state of the battery (secondary battery) of the business operator in the market, and a communication unit (communication device) 8012 for transmitting the degradation tendency analysis value to the battery residual value assessment calibration apparatus 802 via a network.

The battery residual value assessment calibration apparatus 802 includes a detection unit (which may include a communication device) 8021 that receives the degradation tendency analysis value transmitted from the business operator computer 801, a calculation unit (which may include a processor) 8022, and a degradation tendency analysis value storage unit (which may include a storage device) 8023. The calculation unit 8022 matches the degradation tendency analysis value in the actual operating state in the market with a current assessment threshold value (for example, the above-described temporary threshold value) to calibrate the threshold value. Then, the calculation unit 8022 acquires the information about the degradation state (the SOH value, the IR value, the abnormal degradation level, and the residual value rank) of each battery generated by the battery residual value assessment apparatus 303, and newly ranks the secondary battery to be evaluated (the battery 301 diagnosed by the battery residual value assessment apparatus 303) with the new threshold value (calibrated threshold value) (re-evaluation). Since the degradation tendency analysis value is accumulated in the degradation tendency analysis value storage unit 8023 over time, the abnormal degradation level threshold value can be periodically calibrated. Here, the degradation tendency analysis value of the battery in the actual operating state is based on a relationship between the abnormal degradation level and the abnormality occurrence frequency, and may alternatively be based on a relationship between the SOH or IR and the abnormality occurrence frequency.

As in the case of the previously described apparatus, the battery residual value assessment apparatus 303 and the battery residual value assessment calibration apparatus 802 may be integrated as one apparatus (for example, may be implemented on one server computer).

### (v) Market Price Reflection Type Battery Residual Value Correction Apparatus

A battery residual value correction apparatus according to the embodiment provides a function of further correcting the initially set threshold value and/or the threshold value calibrated by the battery residual value assessment calibration function in consideration of a secondhand battery market price in the market (market price reflection type battery residual value correction apparatus).

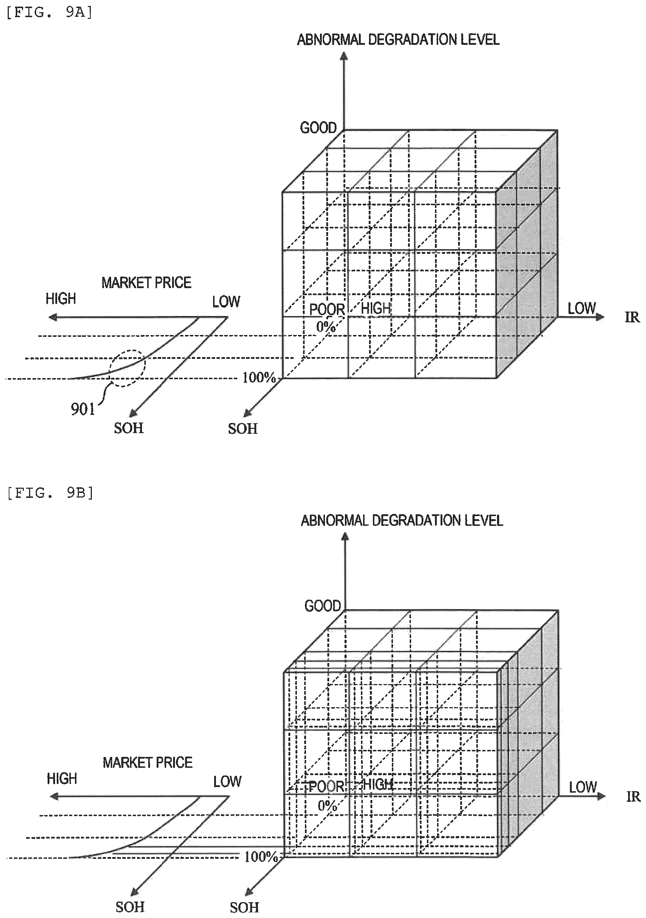

### (v-1) Overview of Battery Residual Value Correction Function: See FIGS. 9A and 9B

FIGS. 9A and 9B show an overview of a battery residual value correction function according to the embodiment. FIG. 9A shows a threshold value before correction (example), and FIG. 9B shows a threshold value after correction (example).

As described with reference to FIG. 1, in the embodiment, ranking is performed according to the degradation state of the battery based on the three indexes of the SOH, the IR, and the abnormal degradation level. The threshold value (basic value) set for each index is set according to a design specification, a customer requirement specification of each business operator, and the like. However, there may be a difference between the setting of the threshold value and a secondhand battery market price in the market. Therefore, by providing a market price reflection type battery residual value correction function, each threshold value is corrected based on the secondhand battery market price in the market to correct a deviation from the market.

Specifically, when the secondhand battery market price in the market is represented with the market price on a horizontal axis and the SOH on a vertical axis, it is assumed that there is a range 901 in which a slope of a change in the market price is large within a certain threshold value range of the SOH as shown in FIG. 9A. In this case, a battery that is actually traded at a high market price and a battery at a low market price co-exist within the same threshold value. Therefore, in order to correctly evaluate the SOH of the battery and the secondhand battery market price in the market, the threshold value is corrected by dividing and subdividing the range in which the slope of the change in the market price is large as shown in FIG. 9B. Here, the threshold value is corrected based on a relationship between the SOH and the market price, and may alternatively be corrected based on a relationship between the IR or the abnormal degradation level and the market price.

### (v-2) Configuration Example of Battery Residual Value Assessment System 101 Including Market Price Reflection Type Battery Residual Value Correction Apparatus

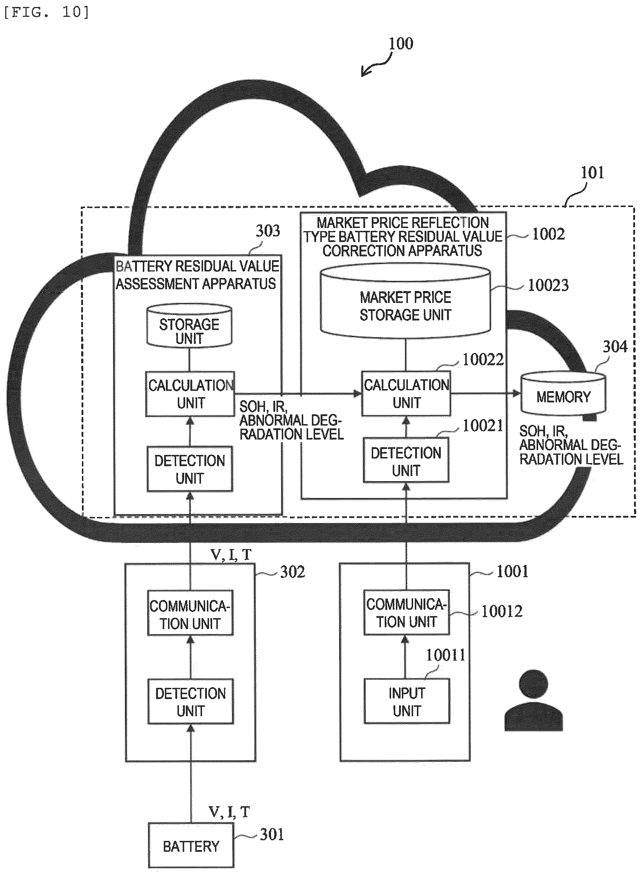

FIG. 10 shows a schematic configuration example of the battery residual value assessment system 101 including the battery residual value correction apparatus according to the embodiment. In FIG. 10, the battery residual value assessment apparatus 303 and a battery residual value correction apparatus 1002 are shown as a cloud server, and may alternatively be implemented in the on-premises form or the edge computing form.

The battery residual value assessment system 101 includes, in addition to the battery residual value assessment apparatus 303 and the memory 304, the battery residual value correction apparatus 1002 that is connected to at least one business operator computer 1001 via a network and is provided in a cloud.

The business operator computer 1001 includes an input unit (which may include a keyboard, a mouse, or the like) 10011 for inputting the secondhand battery market price (for example, information obtained from a database storing a secondhand battery market price value corresponding to a type of the battery) of the battery (secondary battery) of the business operator, and a communication unit (communication device) 10012 for transmitting information about the secondhand battery market price of the target battery to the battery residual value correction apparatus 1002 via a network.

The battery residual value correction apparatus 1002 includes a detection unit (which may include a communication device) 10021 that receives the information about the market price value of the target battery transmitted from the business operator computer 1001, a calculation unit (which may include a processor) 10022, and a market price storage unit (which may include a storage device) 10023. The calculation unit 10022 matches the received secondhand battery market price with a current assessment threshold value (for example, the above-described temporary threshold value) to correct the threshold value. Then, the calculation unit 10022 acquires the information about the degradation state (the SOH value, the IR value, the abnormal degradation level, and the residual value rank) of each battery generated by the battery residual value assessment apparatus 303, and newly ranks the secondary battery to be evaluated (the battery 301 diagnosed by the battery residual value assessment apparatus 303) with the new threshold value (corrected threshold value) (re-evaluation). Since the secondhand battery market price is accumulated in the market price storage unit 10023 over time, the threshold value can be periodically corrected.

As in the case of the previously described apparatus, the battery residual value assessment apparatus 303 and the battery residual value assessment calibration apparatus 1002 may be integrated as one apparatus (for example, may be implemented on one server computer).

### <Battery-Residual-Value-Corresponding Supply Chain System>

### (I) Residual-Value-Based Reservation Function: Function of Distributing and Displaying Reservation Data of Battery-Demanding Business Operator According to Time (Short-Term, Middle-Term, Long-Term, and the Like)

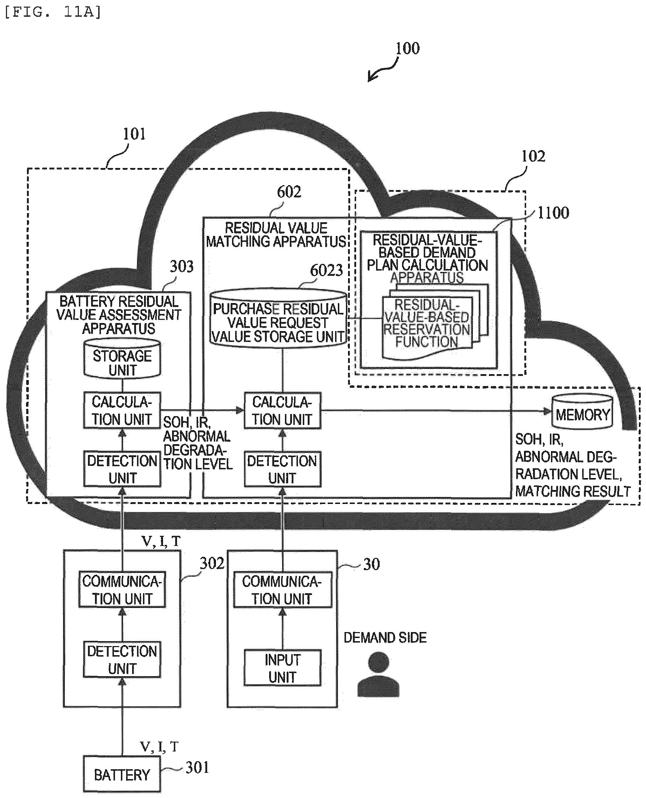

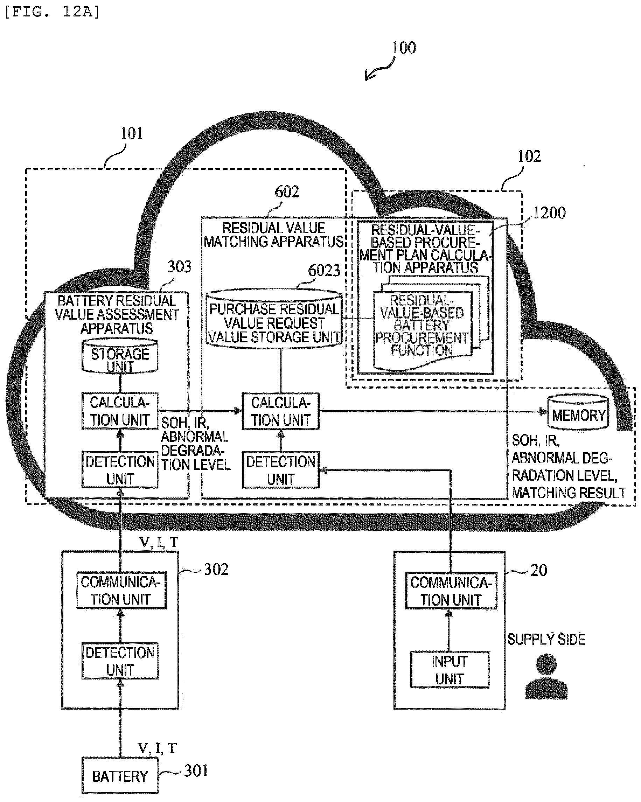

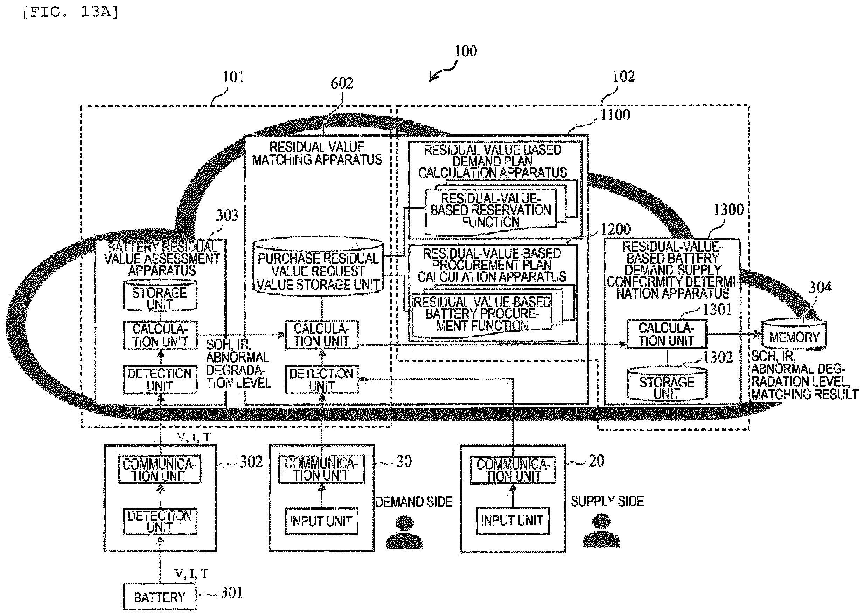

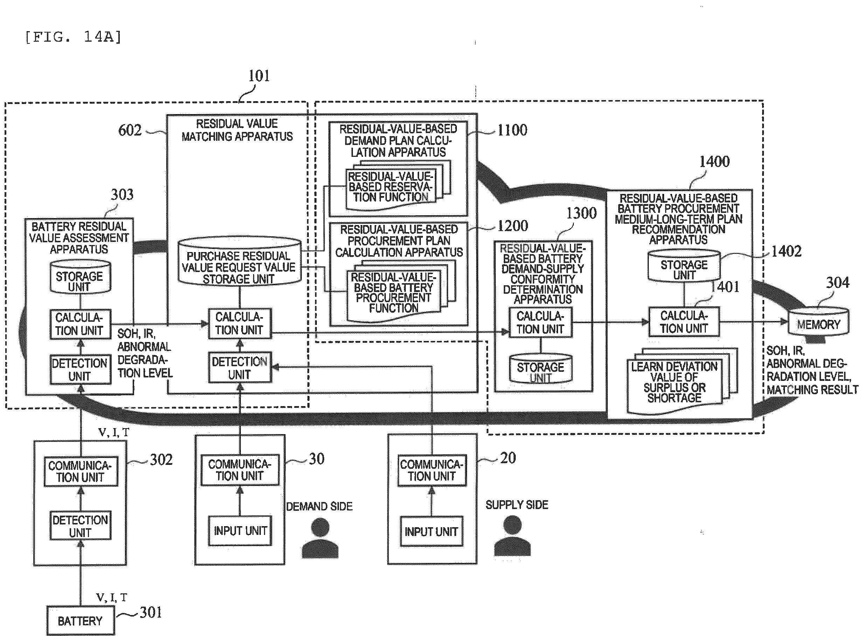

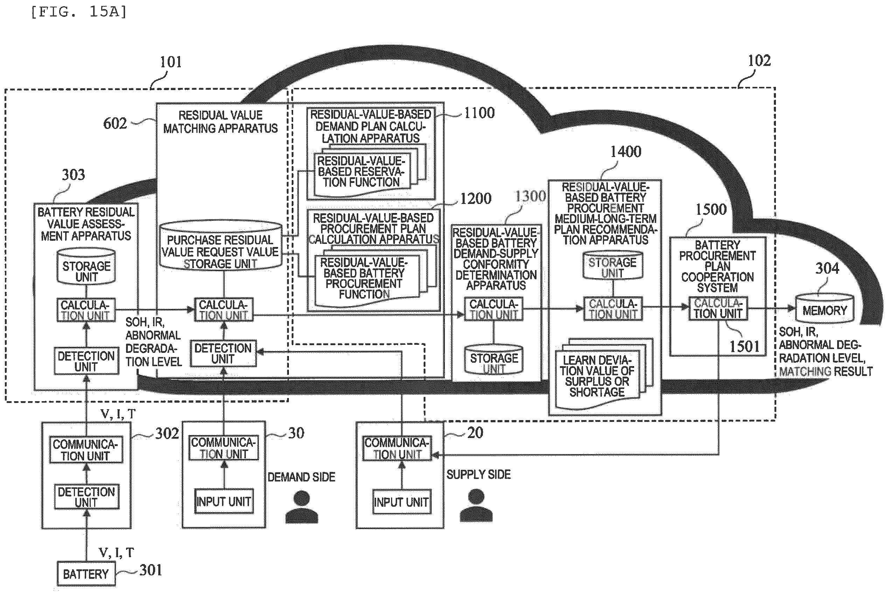

FIG. 11A shows an overall schematic configuration example 1 of the battery residual value management system 100 including the battery-residual-value-corresponding supply chain system 102 according to the embodiment. The battery residual value management system 100 is implemented by adding a residual-value-based demand plan calculation apparatus 1100 that provides a residual-value-based reservation function (short-term, medium-term, and long-term) to the purchase residual value request value storage unit 6023 in the residual value matching apparatus 602 as the battery-residual-value-corresponding supply chain system 102. The battery-residual-value-corresponding supply chain system 102 shown in FIG. 11A includes only the residual-value-based demand plan calculation apparatus 1100 as a component, and may also include at least one of a residual-value-based procurement plan calculation apparatus 1200 (see FIG. 12A), a residual-value-based battery demand-supply conformity determination apparatus 1300 (see FIG. 13A), a residual-value-based battery procurement medium-long-term plan recommendation apparatus 1400 (see FIG. 14A), and a battery procurement plan cooperation system 1500 (see FIG. 15A) as will be described later, in addition to the residual-value-based demand plan calculation apparatus 1100. In FIG. 11A, the battery residual value management system 100 including the battery-residual-value-corresponding supply chain system 102 is shown as a cloud server, and may alternatively be implemented in the on-premises form or the edge computing form.

The residual-value-based demand plan calculation apparatus 1100 acquires residual value data (a battery model, the SOH, the IR, the abnormal degradation level, a quantity, a delivery date, and the like) of a battery requested by a demand side (the battery-demanding business operator computer group 30), organizes information about a reservation status of a demanding business operator candidate destination with reference to data accumulated in the purchase residual value request value storage unit 6023, and displays the information on a screen of a display apparatus (not shown) as necessary. At this time, it is also possible to display the reservation status by classifying the reservation status into a short-term, a medium-term, and a long-term.

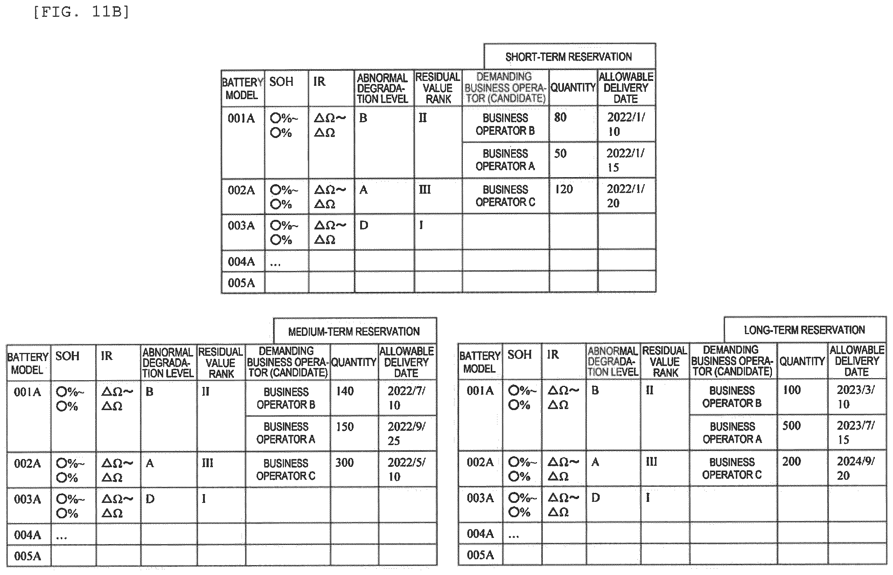

FIG. 11B shows an example of a generated residual-value-based demand plan (short-term, medium-term, and long-term reservation information). The residual-value-based demand plan calculation apparatus 1100 totalizes reservation data (desired battery residual value data: the battery model, the SOH, the IR, the abnormal degradation level, the quantity, the delivery date, and the like) transmitted from the demand side (the battery-demanding business operator computer group 30) and classifies the reservation data into a short-term reservation (for example, the delivery date is within one month), a medium-term reservation (for example, the delivery date is within one year), and a long-term reservation (for example, the delivery date is within five years) as shown in FIG. 11B. For example, first, the short-term reservation, the medium-term reservation, and the long-term reservation are distributed according to a desired delivery date, and data of the battery model, the SOH, the IR, the abnormal degradation level, and the quantity desired by each demanding business operator is summarized in a predetermined format.

### (ii) Residual-Value-Based Battery Procurement Function: Function of Distributing and Displaying Procurement Data of Battery-Supplying Business Operator According to Time (Short-Term, Middle-Term, Long-Term, and the Like)

FIG. 12A shows an overall schematic configuration example 2 of the battery residual value management system 100 including the battery-residual-value-corresponding supply chain system 102 according to the embodiment. The battery residual value management system 100 is implemented by adding the residual-value-based procurement plan calculation apparatus 1200 that provides a residual-value-based battery procurement function (short-term, medium-term, and long-term) to the purchase residual value request value storage unit 6023 in the residual value matching device 602 as the battery-residual-value-corresponding supply chain system 102. The battery-residual-value-corresponding supply chain system 102 shown in FIG. 12A includes only the residual-value-based procurement plan calculation apparatus 1200 as a component, and may also include at least one of the residual-value-based demand plan calculation apparatus 1100 (see FIG. 11A), the residual-value-based battery demand-supply conformity determination apparatus 1300 (see FIG. 13A), the residual-value-based battery procurement medium-long-term plan recommendation apparatus 1400 (see FIG. 14A), and the battery procurement plan cooperation system 1500 (see FIG. 15A) as will be described later, in addition to the residual-value-based procurement plan calculation apparatus 1200. In FIG. 12A, the battery residual value management system 100 including the battery-residual-value-corresponding supply chain system 102 is shown as a cloud server, and may alternatively be implemented in the on-premises form or the edge computing form.

The residual-value-based procurement plan calculation apparatus 1200 acquires procurement plan data (residual value data of a battery that can be provided: the battery model, the SOH, the IR, the abnormal degradation level, the quantity, the delivery date (procurement time), and the like) of each business operator from the supply side (the battery-supplying business operator computer group 20), organizes data of the supply business operator in association with the battery procurement plan data with reference to the data accumulated in the purchase residual value request value storage unit 6023, and displays the data on a screen of a display apparatus (not shown) as necessary. At this time, it is also possible to display a battery procurement plan by classifying the battery procurement plan into a short-term, a medium-term, and a long-term.

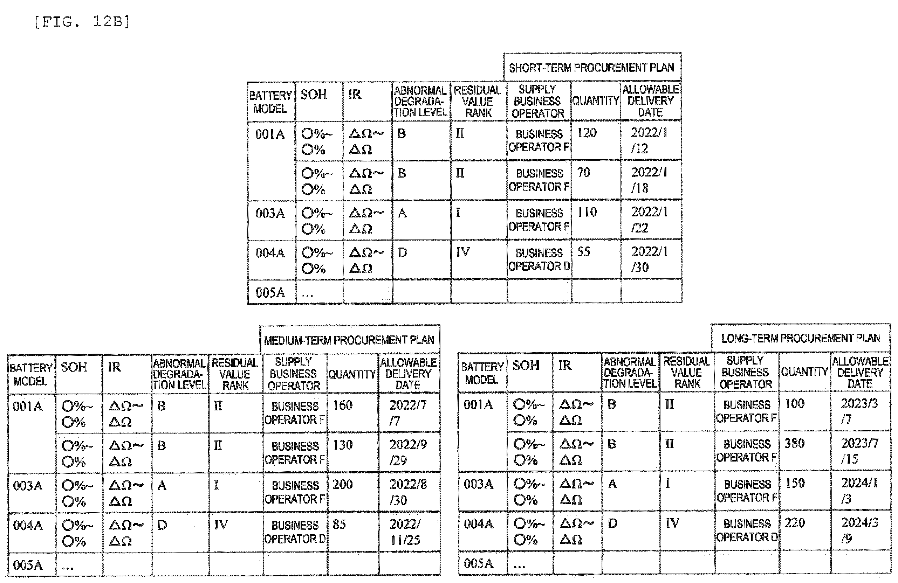

FIG. 12B shows an example of a generated residual-value-based procurement plan (short-term, medium-term, and long-term reservation information). The residual-value-based procurement plan calculation apparatus 1200 totalizes the procurement plan data (residual value data of a battery scheduled to be procured (that can be provided) : the battery model, the SOH, the IR, the abnormal degradation level, the quantity, the delivery date (procurement time), and the like) transmitted from the supply side (the battery-supplying business operator computer group 20) and classifies the procurement plan data into a short-term procurement plan (for example, procurement within one month), a medium-term procurement plan (for example, procurement within one year), and a long-term procurement plan (for example, procurement within five years) as shown in FIG. 12B. For example, first, data is distributed to each of short-term procurement, medium-term procurement, and long-term procurement according to a scheduled procurement time, and data of a battery model, an SOH, an IR, an abnormal degradation level, a quantity, and a delivery date (procurement time) scheduled by each supply business operator is summarized in a predetermined format.

### (iii) Residual-Value-Based Battery Demand-Supply Conformity Determination Function: Function of Matching Residual-Value-Based Reservation Data (FIG. 11B) with Residual-Value-Based Battery Procurement Data (FIG. 12B) to Establish Conformity

FIG. 13A shows an overall schematic configuration example 3 of the battery residual value management system 100 including the battery-residual-value-corresponding supply chain system 102 according to the embodiment. The battery residual value management system 100 is implemented by adding the residual-value-based demand plan calculation apparatus 1100 that provides the residual-value-based reservation function (short-term, medium-term, and long-term), the residual-value-based procurement plan calculation apparatus 1200 that provides the residual-value-based procurement function (short-term, medium-term, and long-term), and the residual-value-based battery demand-supply conformity determination apparatus 1300 that provides a residual-value-based battery demand-supply conformity determination function into a cloud as the battery-residual-value-corresponding supply chain system 102. In FIG. 13A, the battery residual value management system 100 including the battery-residual-value-corresponding supply chain system 102 is shown as a cloud server, and may alternatively be implemented in the on-premises form or the edge computing form.

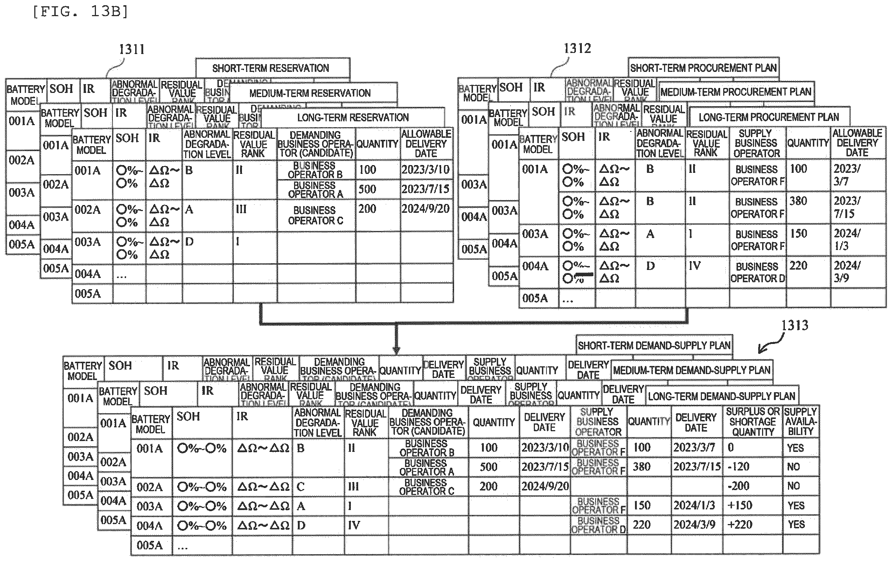

The residual-value-based battery demand-supply conformity determination apparatus 1300 includes a calculation unit 1301 that matches the residual-value-based demand plan data (FIG. 11B) from the residual-value-based demand plan calculation apparatus 1100 and the residual-value-based procurement plan data (FIG. 12B) from the residual-value-based procurement plan calculation apparatus 1200 with data of the degradation state of each battery obtained by calculation in the battery residual value assessment apparatus 303, and generates a residual-value-based battery demand-supply conformity determination result (see FIG. 13B) including information about a surplus or shortage quantity and supply availability of each battery, and a storage unit 1302 that stores the residual-value-based battery demand-supply conformity determination result. The calculation unit 1301 also stores the residual-value-based battery demand-supply conformity determination result in the memory 304 for screen display or for provision to the supply side and the demand side. Accordingly, it is possible to present short-term, medium-term, and long-term demand-supply plans.

FIG. 13B shows a configuration example of the residual-value-based battery demand-supply conformity determination result. As shown in FIG. 13B, residual-value-based demand plan data 1313 (the same data as in FIG. 11B) and residual-value-based procurement plan data 1312 (the same data as in FIG. 12B) are compared for each delivery date (short-term, medium-term, and long-term), and a battery that can be supplied (procurement plan) on the supply side is allocated to a battery desired on the demand side (reservation: demand plan). Specifically, conformity state determination is "yes" when the surplus or shortage quantity is 0 or + (plus), and is "no" when the surplus or shortage quantity is - (minus). That is, "yes" is input as supply availability information for a battery model that can satisfy the reservation, and "no" is input as the supply availability information for a battery model that is in shortage (see the residual-value-based battery demand-supply conformity determination result 1313). Accordingly, the supply side can be notified in advance when the battery is in surplus, and meanwhile, the demand side can be notified in advance before the battery is in shortage.

### (iv) Residual-Value-Based Battery Procurement Medium-Long-Term Plan Recommendation Function: Function of Learning Residual-Value-Based Battery Demand-Supply Conformity Determination History (Deviation Value of Surplus or Shortage) by Residual-Value-Based Battery Demand-Supply Conformity Determination Function and Recommending Amount to Be Procured in Advance

FIG. 14A shows an overall schematic configuration example 4 of the battery residual value management system 100 including the battery-residual-value-corresponding supply chain system 102 according to the embodiment. The battery residual value management system 100 is implemented by adding the residual-value-based demand plan calculation apparatus 1100 that provides the residual-value-based reservation function (short-term, medium-term, and long-term), the residual-value-based procurement plan calculation apparatus 1200 that provides the residual-value-based procurement function (short-term, medium-term, and long-term), the residual-value-based battery demand-supply conformity determination apparatus 1300 that provides the residual-value-based battery demand-supply conformity determination function, and the residual-value-based battery procurement medium-long-term plan recommendation apparatus 1400 into a cloud as the battery-residual-value-corresponding supply chain system 102. In FIG. 14A, the battery residual value management system 100 including the battery-residual-value-corresponding supply chain system 102 is shown as a cloud server, and may alternatively be implemented in the on-premises form or the edge computing form.

The residual-value-based battery procurement medium-long-term plan recommendation apparatus 1400 includes a calculation unit (processor) 1401 that learns a deviation value of surplus or shortage with respect to data accumulated by residual-value-based battery demand-supply conformity determination apparatus 1300 and derives future supply prediction and demand prediction by applying, for example, random forest to the deviation value, and a storage unit 1402 that stores data of the future supply prediction and demand prediction. The calculation unit 1401 temporarily stores the data of the future supply prediction and demand prediction in the memory 304 in order to display the data of the future supply prediction and demand prediction on a display screen of a display apparatus (not shown) as necessary.

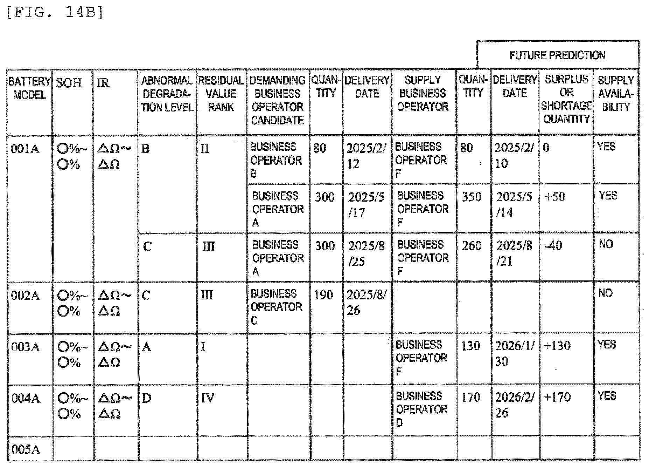

Specifically, in the residual-value-based battery procurement medium-long-term plan recommendation apparatus 1400, the calculation unit 1401 calculates a surplus or shortage quantity predicted for the future based on a result of the future supply prediction and demand prediction, and displays the surplus or shortage quantity on the display screen (see FIG. 14B). The calculation unit 1401 predicts, based on the degradation tendency analysis value or the secondhand battery market price in an actual operating state in the market in the past, threshold values of the three indexes (SoH, IR, and abnormal degradation level) indicating the degradation state of the battery, which may change from the present to the future, minimiz_es a difference between demand and supply, and recommends an optimal operation.

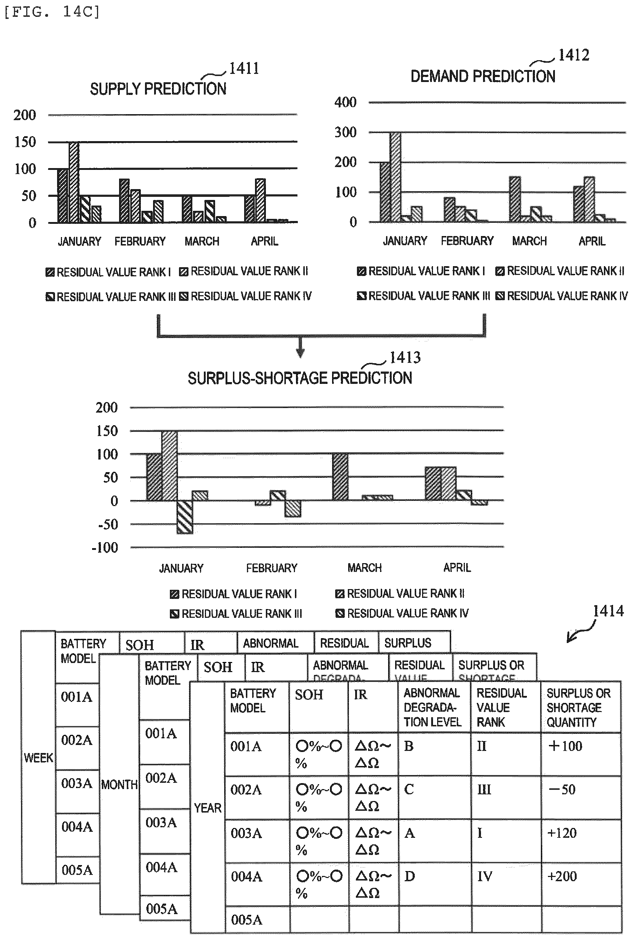

FIG. 14C shows a concept of surplus-shortage prediction. It is assumed that, for example, supply prediction 1411 and demand prediction 1412 are obtained as a result of executing the residual-value-based battery procurement medium-long-term plan recommendation function. Here, the calculation unit 1401 compares the supply prediction 1411 with the demand prediction 1412 for each predetermined period (for example, for each month) and for each residual value rank (for example, from I to IV), determines whether there is surplus and whether there is shortage (whether there is a deviation in demand-supply prediction), and generates surplus-shortage prediction data 1413. In the example in FIG. 14C, the monthly surplus-shortage prediction 1413 is shown as a bar graph, and the surplus-shortage prediction may be generated and output weekly and yearly. The calculation unit 1401 generates medium-long-term plan recommendation information 1414 about various batteries (various batteries specified by information from the battery model to the residual value rank). The medium-long-term plan recommendation information 1414 can be provided to the demand side and the supply side. Accordingly, it is possible to establish a future procurement plan of the various batteries on the supply side and establish a reservation plan of the various batteries on the demand side.

### (v) Battery Procurement Plan Cooperation Function: Function of Linking Battery Procurement Destination Vendor Matching Medium-Long-Term Procurement Plan of Residual-Value-Based Battery Procurement Medium-Long-Term Plan Recommendation Function with Residual-Value-Based Required Procurement Amount Information Recommended by Residual-Value-Based Battery Procurement Medium-Long-Term Plan Recommendation Function

FIG. 15A shows an overall schematic configuration example 5 of the battery residual value management system 100 including the battery-residual-value-corresponding supply chain system 102 according to the embodiment. The battery residual value management system 100 is implemented by adding the residual-value-based demand plan calculation apparatus 1100 that provides the residual-value-based reservation function (short-term, medium-term, and long-term), the residual-value-based procurement plan calculation apparatus 1200 that provides the residual-value-based procurement function (short-term, medium-term, and long-term), the residual-value-based battery demand-supply conformity determination apparatus 1300 that provides the residual-value-based battery demand-supply conformity determination function, the residual-value-based battery procurement medium-long-term plan recommendation apparatus 1400, and the battery procurement plan cooperation system 1500 into a cloud as the battery-residual-value-corresponding supply chain system 102. In FIG. 15A, the battery residual value management system 100 including the battery-residual-value-corresponding supply chain system 102 is shown as a cloud server, and may alternatively be implemented in the on-premises form or the edge computing form.

In the battery procurement plan cooperation system 1500, a calculation unit 1501 acquires future prediction data generated by the residual-value-based battery procurement medium-long-term plan recommendation apparatus 1400, summarizes information such as a predicted demand-supply quantity and a delivery date of each battery in a medium-long term for each business operator, displays the information on a display apparatus (not shown), and stores the information in the memory 304 to present the information to each business operator. Accordingly, cooperation between information display in the battery-residual-value-corresponding supply chain system 102 and information presentation (display) to the battery-supplying business operator computer group 20 is enabled.

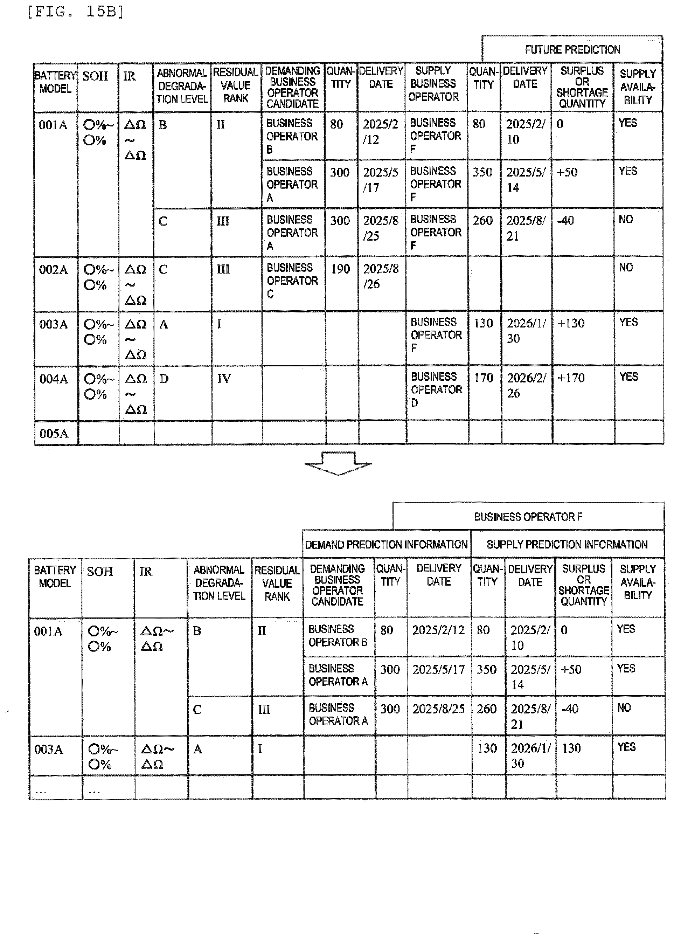

For example, when battery surplus is predicted in a medium-long-term plan in the acquired future prediction data, it is recommended that a battery is retained for a longer period of time. However, since the retaining incurs a management cost and a progress of battery degradation, the battery procurement plan cooperation system 1500 presents (proposes), to each battery-supplying business operator, based on demand-supply prediction, demand generation time of the target battery and provision of a battery whose supply is insufficient and which has a different residual value rank. Specifically, it is proposed to provide a battery of the residual value rank II close to the residual value rank III (a battery of the residual value rank II close to a boundary (threshold value) between the residual value rank II and the residual value rank III) as the residual value rank III. In addition, utilization for adjustment of a production and procurement quantity is enabled. Referring to FIG. 15B (which shows a result of battery provision adjustment based on the future prediction data), for example, when a supply business operator F cannot supply forty batteries of a battery model 001A of the residual value rank III to a demanding business operator A (candidate), it is recommended that surplus batteries of the battery model 001A of the residual value rank II are supplied as being equivalent to the residual value rank III.

### <Battery-Residual-Value-Corresponding Maintenance Management System>

### (i) Guarantee-Service-Providing Type Matching Function: Function of Providing Guarantee Service in Conjunction with Grade Based Particularly on Abnormal Degradation Level of Third Index in Residual Value Matching Result of Residual Value Matching Apparatus 602

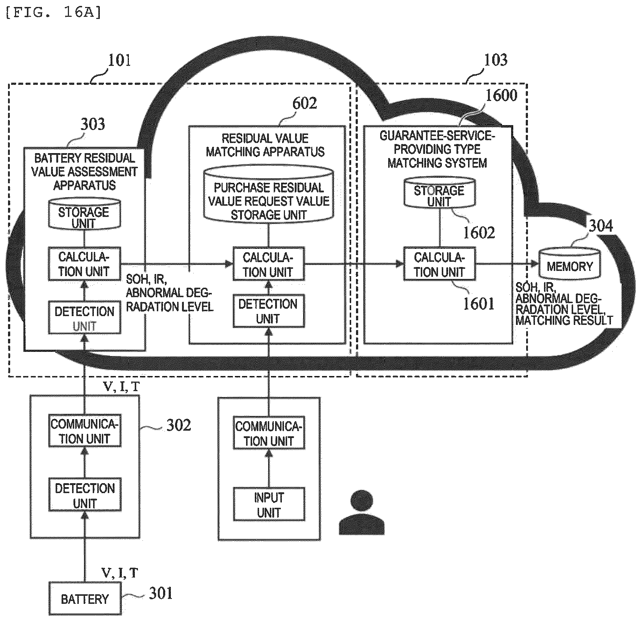

FIG. 16A shows an overall schematic configuration example 1 of the battery residual value management system 100 including the battery-residual-value-corresponding maintenance management system 103 according to the embodiment. The battery residual value management system 100 is implemented by adding a guarantee-service-providing type matching system 1600 in a cloud as the battery-residual-value-corresponding maintenance management system 103. In FIG. 16A, the battery residual value management system 100 including the battery-residual-value-corresponding maintenance management system 103 is shown as a cloud server, and may alternatively be implemented in the on-premises form or the edge computing form. In FIG. 16A, the guarantee-service-providing type matching system 1600 is connected to the residual value matching apparatus 602, but the residual value matching apparatus 602 is not an essential component, and the guarantee-service-providing type matching system 1600 may be directly connected to the battery residual value assessment apparatus 303.

In a calculation unit (processor) 1601, the guarantee-service-providing type matching system 1600 determines a guarantee service content and a guarantee cost based on the abnormal degradation level (grade A, B, C, D, ...) of the battery indicated in the residual value matching result and stores the determined contents in a storage unit 1602 and the memory 304. When the determined contents are presented to the demanding business operator or the like, the information stored in the memory 304 is used.

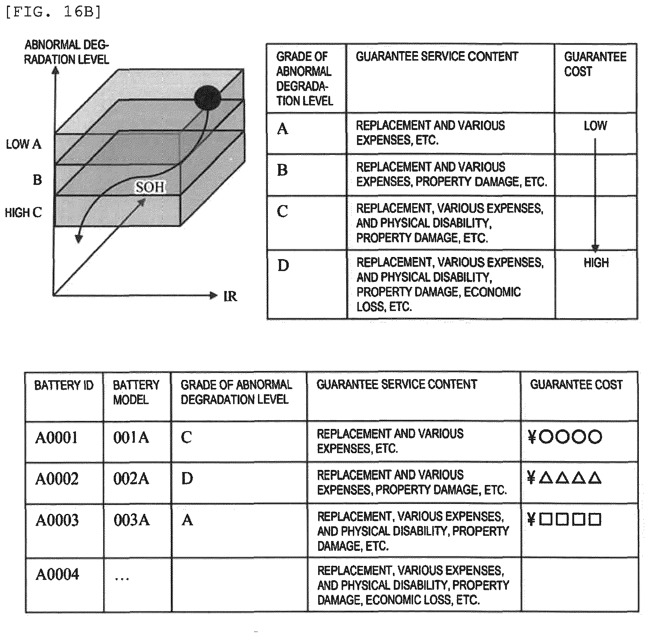

FIG. 16B shows the guarantee service content (upper table) corresponding to the abnormal degradation level of the battery and a guarantee service provision result (lower table) determined for each battery. As shown in FIG. 16B (upper table), the guarantee service content and the guarantee cost can be set to be different according to the grade of the abnormal degradation level. In FIG. 16B, the guarantee content differs according to the grade of the abnormal degradation level, and the guarantee content may be the same whereas only the guarantee cost differs.

For example, as shown in FIG. 16B (upper table), when a battery of the abnormal degradation level grade B is purchased, it is possible to provide the guarantee service content covering replacement and various expenses, and property damage. Based on a diagnosis result performed together with update of the guarantee service, it is recommended to change the guarantee service content according to the abnormal degradation level grade when the grade is changed.

### (ii) Degradation-monitoring-Service-Providing Type Matching Function: Function of Providing Degradation Guarantee Service During Operation in Conjunction with Grade Based Particularly on Abnormal Degradation Level of Third Index in Residual Value Matching Result of Residual Value Matching Apparatus 602

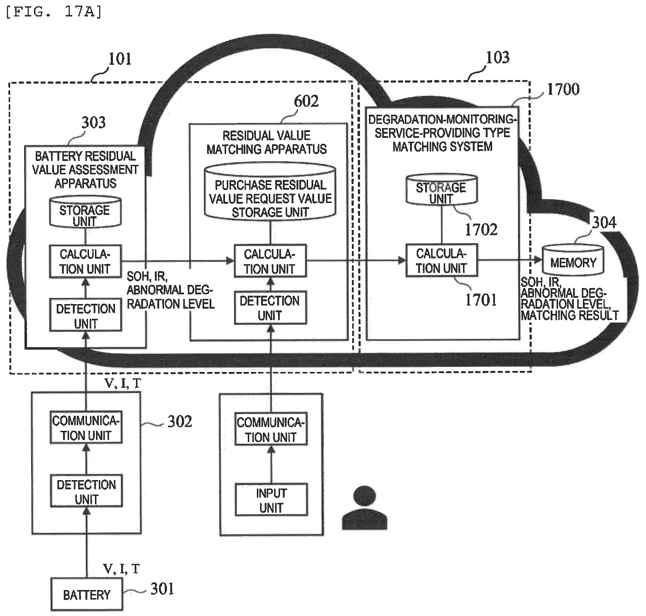

FIG. 17A shows an overall schematic configuration example 2 of the battery residual value management system 100 including the battery-residual-value-corresponding maintenance management system 103 according to the embodiment. The battery residual value management system 100 is implemented by adding a degradation-monitoring-service-providing type matching system 1700 in a cloud as the battery-residual-value-corresponding maintenance management system 103. In FIG. 17A, the battery residual value management system 100 including the battery-residual-value-corresponding maintenance management system 103 is shown as a cloud server, and may alternatively be implemented in the on-premises form or the edge computing form. In FIG. 17A, the degradation-monitoring-service-providing type matching system 1700 is connected to the residual value matching apparatus 602, but the residual value matching apparatus 602 is not an essential component, and the degradation-monitoring-service-providing type matching system 1700 may be directly connected to the battery residual value assessment apparatus 303.

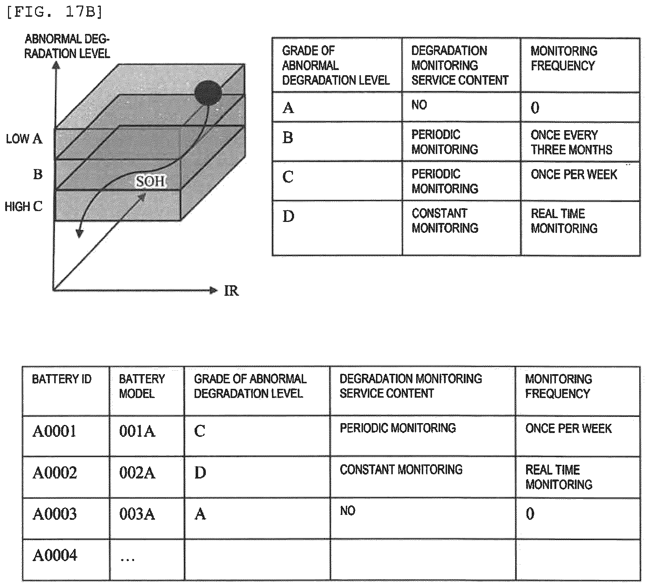

Since a risk of occurrence of an abnormality differs depending on the battery, the degradation-monitoring-service-providing type matching system 1700 provides a degradation monitoring service according to each grade of the abnormal degradation level of the battery based on the grade. Specifically, for example, a calculation unit (processor) 1701 refers to degradation monitoring service information (FIG. 17B) corresponding to the grade of the abnormal degradation level stored in a storage unit 1702, determines a degradation monitoring service content and monitoring frequency based on the abnormal degradation level (grade A, B, C, D, ...) of the battery indicated in the acquired residual value matching result, and stores the determined contents in the storage unit 1702 and the memory 304. When the determined contents are presented to the demanding business operator or the like, the information stored in the memory 304 is used.

Since the degradation of the battery progresses according to an operation state of the battery, the monitoring function includes, for example, processing of comparing, by the calculation unit 1701, a past diagnosis result of the target battery stored in the storage unit 1702 with a diagnosis result newly obtained through periodic monitoring or constant monitoring, and calculating a fluctuation in the abnormal degradation level, and processing of changing, by the calculation unit 1701, when there is a change in the abnormal degradation level, a service to be applied in conjunction with the changed abnormal degradation level. As a method for acquiring battery data in the periodic monitoring or the constant monitoring, there is a method of simultaneously performing diagnostics, for example, during battery charging or periodic maintenance in the case of the periodic monitoring, and acquiring data via a battery management system (BMS: a system for safety control of a secondary battery), for example, in the case of the constant monitoring.

FIG. 17B shows the degradation monitoring service content (upper table) corresponding to the abnormal degradation level of the battery and the guarantee service provision result (lower table) determined for each battery. As shown in FIG. 17B (upper table), the degradation monitoring service content and the monitoring frequency can be set to differ according to the grade of the abnormal degradation level.

### (iii) Battery Operation Maintenance Management Function: Function of Optimizing Maintenance Management by Comprehensively Considering Residual Value and Reliability during Operation

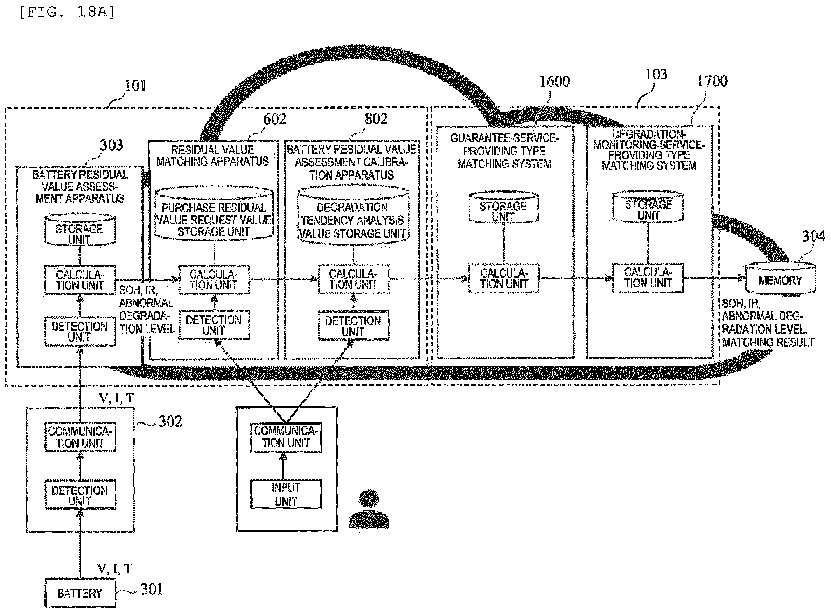

FIG. 18A shows an overall schematic configuration example 3 of the battery residual value management system 100 including the battery-residual-value-corresponding maintenance management system 103 according to the embodiment. The battery residual value management system 100 is implemented by adding the guarantee-service-providing type matching system 1600 and the degradation-monitoring-service-providing type matching system 1700 in a cloud as the battery-residual-value-corresponding maintenance management system 103. In FIG. 18A, the battery residual value management system 100 including the battery-residual-value-corresponding maintenance management system 103 is shown as a cloud server, and may alternatively be implemented in the on-premises form or the edge computing form.

The battery-residual-value-corresponding maintenance management system 103 according to FIG. 18A provides a function (battery operation maintenance management function) of allocating the guarantee service and the degradation monitoring service to a matching result determined by the residual value matching apparatus 602 based on an evaluation (assessment) result of the residual value of the battery using a threshold value calibrated by the battery residual value assessment calibration apparatus 802 in consideration of degradation tendency analysis of the battery. Accordingly, it is possible to implement maintenance management in which a variation (reliability) of a degree of battery degradation during a battery operation and the residual value of the battery are comprehensively determined.

In the battery residual value management system 100 according to FIGS. 16A and 17A, the abnormal degradation level is graded according to the operation state of the target battery based on a threshold value set based on a battery characteristic and a design value. However, there may be a difference between the setting of the threshold value and occurrence frequency of a battery abnormality or failure occurring in the market. Therefore, by applying a threshold value (a threshold value calibrated by the battery residual value assessment calibration function) derived from occurrence frequency data of a battery abnormality occurring in the market, the guarantee (insurance) service content and the monitoring service content presented and provided for each battery are optimized. Then, the threshold value of the battery is continuously updated to improve determination accuracy. Contents of updated threshold value data can also be reflected in a fee structure and a price of an insurance and monitoring service.

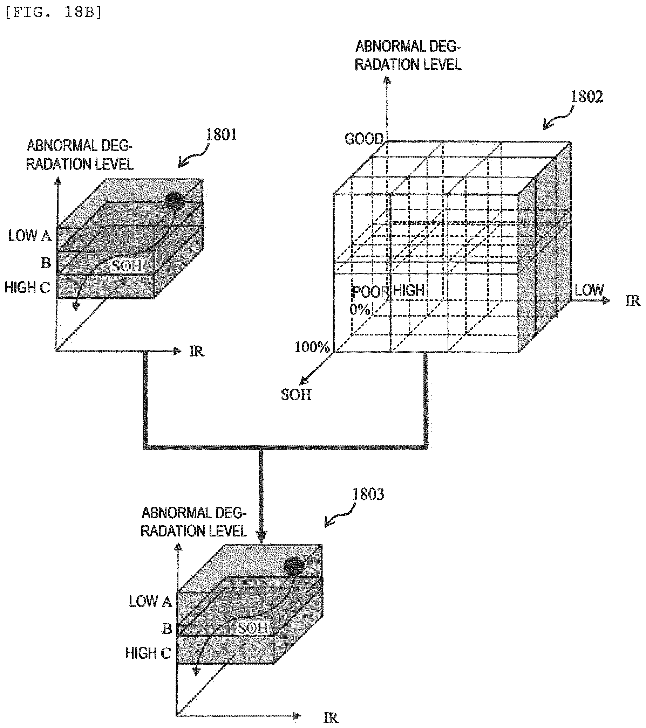

Determination of the guarantee service content and the guarantee cost, and determination of the degradation monitoring service content and the monitoring frequency are performed with reference to the guarantee service content (upper table in FIG. 16B) corresponding to the abnormal degradation level of the battery and the degradation monitoring service content (upper table in FIG. 17B) corresponding to the abnormal degradation level of the battery. However, in the aspect shown in FIG. 18A, since the threshold value for determining the grade of the abnormal degradation level is changed by performing the battery residual value assessment calibration as described above, the change is reflected in the determination of the guarantee service content and the degradation monitoring service content. FIG. 18B shows a state in which the threshold value calibrated by the battery residual value assessment calibration function is reflected in the determination of the guarantee service content and the degradation monitoring service content. As indicated by reference numeral 1801 in FIG. 18B, before the threshold value calibration by the battery residual value assessment calibration function, for example, the grade of the abnormal degradation level is equally classified, and the guarantee service content and the degradation monitoring service content are determined based on the grade. Meanwhile, when the threshold value for determining the grade of the abnormal degradation level is changed by the battery residual value assessment calibration function as indicated by reference numeral 1802, determination ranges of the guarantee service content and the degradation monitoring service content are also changed in conjunction with the change as indicated by reference numeral 1803.

### <Modification>

### (i) Modification of Battery Residual Value Management System 100

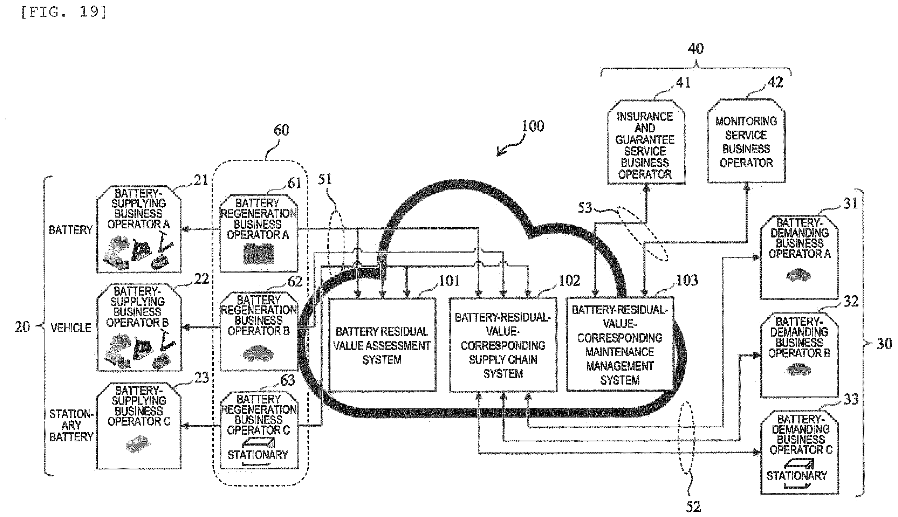

FIG. 19 shows a schematic configuration example of the battery residual value management system 100 according to a modification. In this modification, a battery regeneration business operator computer group 60 is provided between the battery residual value assessment system 101, the battery-residual-value-corresponding supply chain system 102, and the battery-supplying business operator computer group 20. Accordingly, not only data from the battery-supplying business operator but also data from the battery regeneration business operator can be used. For example, the system is configured such that the battery regeneration business operator can upload battery data supplied from the battery-supplying business operator to the battery regeneration business operator to the battery residual value assessment system 101 and/or the battery-residual-value-corresponding supply chain system 102. Accordingly, the residual value of the battery can be assessed and used for secondary use of the battery. The battery-residual-value-corresponding supply chain system 102 can acquire data from the battery regeneration business operator computer group 60 and the battery-demanding business operator computer group 30, and optimize battery demand and supply.

(ii) The battery residual value management system 100 may include at least one of the above-described functions. However, the functions established by cooperation need to be implemented as one set. For example, since the residual-value-based reservation function of the residual-value-based demand plan calculation apparatus 1100 and the residual-value-based battery procurement function of the residual-value-based procurement plan calculation apparatus 1200 require the residual value matching function to be executed by the residual value matching apparatus 602 as a precondition, the battery residual value management system 100 cannot be established only with the residual-value-based demand plan calculation apparatus 1100 and the residual-value-based procurement plan calculation apparatus 1200. On the other hand, the battery residual value assessment calibration function of the battery residual value assessment calibration apparatus 802 can be established as the battery residual value management system 100 as long as the battery residual value assessment apparatus 303 is provided as a precondition, and the residual value matching apparatus 602 is not an essential component.

### <Summary>

(i) According to the embodiment, the battery residual value management system 100 retains, in at least one storage device, information (see FIG. 2A) about a multi-dimensional vector space (three-or-more-dimensional space) formed by at least three indexes for evaluating a residual value of a battery (secondary battery), the multi-dimensional vector space including a plurality of regions for determining a residual value rank of the battery, each of the plurality of regions being defined by one or more threshold values set for each index (for example, an SOH, internal-resistance-related information (IR: for example, internal resistance increase rate), and an abnormal degradation level) in the multi-dimensional vector space. The system 100 acquires the information about the multi-dimensional vector space from the storage device and determines, based on at least three indexes (obtained by calculation based on measured values received from the outside (a charging and discharging apparatus or a computer connected via a network)) of the battery that is a residual value assessment target, to which of the plurality of regions of the multi-dimensional vector space the battery being the residual value assessment target belongs, thereby determining the residual value rank of the battery that is the residual value assessment target. In this way, it is possible to more accurately determine the residual value rank of the battery.

The battery residual value management system 100 causes the residual value matching apparatus 602 to extract, from a plurality of batteries for which the residual value rank is determined by the battery residual value assessment apparatus 303, a battery matching a desired specification range (a desired SOH value or range, a desired IR value or range, a desired grade of the abnormal degradation level) received from the outside (for example, computers 31, 32, 33, ... of a battery-demanding business operator), and output the extracted information. In this way, it is possible to present a customer business operator (demanding business operator) candidate that can be provided to each battery whose degradation state is diagnosed.

The battery residual value management system 100 causes the battery residual value assessment calibration apparatus 802 to acquire, from the outside (for example, a battery degradation database for each business form and each battery actual operating state of the battery), degradation information about the battery in an actual operating state, construct, based on the degradation information, degradation tendency information (see FIG. 7A: for example, a graph having a plurality of change points) about the battery in the actual operating state, execute processing of calibrating one or more threshold values (for example, a threshold value for determining the grade of the abnormal degradation level) of the index (for example, the abnormal degradation level) based on the degradation tendency information, and determine (correct), using the calibrated threshold value, the residual value rank of the battery that is the residual value assessment target. In this way, the threshold value of the index can be calibrated according to the actual operating state, the multi-dimensional vector space can be more accurately divided into a plurality of regions by reflecting the calibrated threshold value, and thus the residual value of the battery can be more accurately evaluated.

The battery residual value management system 100 causes the market price reflection type battery residual value correction apparatus 1002 to acquire, from the outside (for example, a market price database that manages a market price of a secondhand battery), market price information about the battery corresponding to a value of the index (for example, SOH), execute processing of correcting the one or more threshold values of the index based on the market price information, and determine (correct), using the corrected threshold value, the residual value rank of the battery that is the residual value assessment target. In this way, the threshold value of the index can be calibrated according to the market price, the multi-dimensional vector space can be more accurately divided into a plurality of regions by reflecting the calibrated threshold value, and thus the residual value of the battery can be more accurately evaluated.

The battery residual value management system 100 causes the residual-value-based demand plan calculation apparatus 1100 to acquire, from the outside (battery-demanding business operator computer group 30), battery reservation information including residual value data, a quantity, and a delivery date of a desired battery, summarize the battery reservation information based on a type of the battery, and output the summarized battery reservation information as demand plan information. The battery reservation information may be classified into a short-term reservation, a medium-term reservation, and a long-term reservation according to timing of the delivery date, summarized for each classification, and output as the demand plan information. In this way, it is possible to manage which battery is needed at which time and in what quantity.

The battery residual value management system 100 causes the residual-value-based procurement plan calculation apparatus 1200 to acquire, from the outside (battery-supplying business operator computer group 20), battery procurement information including residual value data, a quantity, and a delivery date of a battery available on a supply side, summarize the battery procurement information based on a type of the battery, and output the summarized battery procurement information as procurement plan information. The battery procurement information may be classified into a short-term procurement, a medium-term procurement, and a long-term procurement according to timing of the delivery date of the supply side, summarized for each classification, and output as the procurement plan information. In this way, it is possible to manage which battery can be supplied at which time and in what quantity.

The battery residual value management system 100 is provided with the residual-value-based demand plan calculation apparatus 1100 and the residual-value-based procurement plan calculation apparatus 1200, and is further provided with the residual-value-based battery demand-supply conformity determination apparatus 1300. In the residual-value-based battery demand-supply conformity determination apparatus 1300, the demand plan information is matched with the procurement plan information to determine a balance between demand and supply of each battery (surplus or shortage quantity and availability).

The battery residual value management system 100 includes the residual-value-based battery procurement medium-long-term plan recommendation apparatus 1400 in addition to the residual-value-based demand plan calculation apparatus 1100, the residual-value-based procurement plan calculation apparatus 1200, and the residual-value-based battery demand-supply conformity determination apparatus 1300, generate, by executing machine learning (for example, random forest can be applied) on information indicating the balance between demand and supply of each battery (deviation value of surplus or shortage), prediction information including future supply prediction and demand prediction, and output the prediction information. The battery residual value management system 100 causes the battery procurement plan cooperation system 1500 to generate, based on the prediction information, recommendation information about battery supply, and transmit the recommendation information to a computer on the supply side and/or the demand side (cooperation display can be performed between the battery residual value management system 100 and the computer group 20 and/or 30 on the business operator side). By providing such prediction information (recommendation information) to the demand side and the supply side, it is possible to minimize a difference (deviation) between demand and supply, and to enable an optimal battery market operation.

The battery residual value management system 100 causes the guarantee-service-providing type matching system 1600 to determine and output a guarantee service content of the battery according to a grade of the abnormal degradation level of the battery. Accordingly, it is possible to provide the guarantee service according to the grade of the abnormal degradation level of the battery. The battery residual value management system 100 causes the degradation-monitoring-service-providing type matching system 1700 to determine and output a degradation monitoring service content of the battery according to the grade of the abnormal degradation level of the battery. Accordingly, it is possible to provide the degradation monitoring service according to the grade of the abnormal degradation level of the battery. The guarantee service content of the battery and the degradation monitoring service content of the battery may be determined according to the grade of the abnormal degradation level determined based on the calibrated threshold value. Accordingly, the service can be provided more accurately.

(ii) In the embodiment, control lines and information lines considered to be necessary for description are shown, and not all of the control lines and the information lines are necessarily shown in a product. All the configurations may be connected to one another.

To those having ordinary knowledge in the technical field, other implementations of the disclosure will become apparent from consideration of the specification of the disclosure and the embodiments disclosed herein. Various aspects and/or components of the embodiments described above can be used alone or in any combination. The specification and the specific examples are merely typical, and the scope and spirit of the disclosure are indicated by the following claims.

### Reference Signs List

100 battery residual value management system
101 battery residual value assessment system
102 battery-residual-value-corresponding supply chain system
103 battery-residual-value-corresponding maintenance management system
20 battery-supplying business operator computer group
30 battery-demanding business operator computer group
40 service business operator computer group
51, 52, 53 network
303 battery residual value assessment apparatus
602 residual value matching apparatus
802 battery residual value assessment calibration apparatus
1002 market price reflection type battery residual value correction apparatus
1100 residual-value-based demand plan calculation apparatus
1200 residual-value-based procurement plan calculation apparatus
1300 residual-value-based battery demand-supply conformity determination apparatus
1400 residual-value-based battery procurement medium-long-term plan recommendation apparatus
1500 battery procurement plan cooperation system
1600 guarantee-service-providing type matching system
1700 degradation-monitoring-service-providing type matching system

## Claims

1. A battery residual value management system that manages a residual value of a battery, comprising:
at least one storage device configured to store information about a multi-dimensional vector space formed by at least three indexes for evaluating the residual value of the battery, the multi-dimensional vector space including a plurality of regions for determining a residual value rank of the battery, each of the regions being a region defined by one or more threshold values set for each index in the multi-dimensional vector space; and
at least one processor configured to acquire the information about the multi-dimensional vector space from the storage device and determine, based on the at least three indexes of the battery that is a residual value assessment target, to which of the plurality of regions in the multi-dimensional vector space the battery being the residual value assessment target belongs, thereby determining the residual value rank of the battery that is the residual value assessment target.

2. The battery residual value management system according to claim 1, wherein
the multi-dimensional vector space is formed by indexes including an SOH of the battery, internal-resistance-related information of the battery, and an abnormal degradation level of the battery.

3. The battery residual value management system according to claim 1, wherein
the processor extracts, from a plurality of batteries for which the residual value rank is determined, a battery matching a desired specification range received from outside, and outputs the extracted information.

4. The battery residual value management system according to claim 1, wherein
the processor acquires, from outside, degradation information about the battery in an actual operating state, constructs, based on the degradation information, degradation tendency information about the battery in the actual operating state, executes processing of calibrating the one or more threshold values of the index based on the degradation tendency information, and determines, using the calibrated threshold value, the residual value rank of the battery that is the residual value assessment target.

5. The battery residual value management system according to claim 1, wherein
the processor acquires, from outside, market price information about the battery corresponding to a value of the index, executes processing of correcting the one or more threshold values of the index based on the market price information, and determines, using the corrected threshold value, the residual value rank of the battery that is the residual value assessment target.

6. The battery residual value management system according to claim 3, wherein
the processor acquires, from outside, battery reservation information including residual value data, a quantity, and a delivery date of a battery desired by a demand side, summarizes the battery reservation information based on a type of the battery, and outputs the summarized battery reservation information as demand plan information.

7. The battery residual value management system according to claim 6, wherein
the processor classifies the battery reservation information into a short-term reservation, a medium-term reservation, and a long-term reservation according to timing of the delivery date, summarizes the battery reservation information for each classification, and outputs the summarized battery reservation information as the demand plan information.

8. The battery residual value management system according to claim 3, wherein
the processor acquires, from outside, battery procurement information including residual value data, a quantity, and a delivery date of a battery available on a supply side, summarizes the battery procurement information based on a type of the battery, and outputs the summarized battery procurement information as procurement plan information.

9. The battery residual value management system according to claim 8, wherein
the processor classifies the battery procurement information into a short-term procurement, a medium-term procurement, and a long-term procurement according to timing of the delivery date of the supply side, summarizes the battery procurement information for each classification, and outputs the summarized battery procurement information as the procurement plan information.

10. The battery residual value management system according to claim 6, wherein
the processor acquires, from outside, battery procurement information including residual value data, a quantity, and a delivery date of a battery available on a supply side, summarizes the battery procurement information based on a type of the battery, and outputs the summarized battery procurement information as procurement plan information.

11. The battery residual value management system according to claim 10, wherein
the processor matches the demand plan information with the procurement plan information to determine a balance between demand and supply of each battery.

12. The battery residual value management system according to claim 11, wherein
the processor generates, by executing machine learning on information indicating the balance between demand and supply of each battery, prediction information including future supply prediction and demand prediction, and outputs the prediction information.

13. The battery residual value management system according to claim 12, wherein
the processor is configured to generate, based on the prediction information, recommendation information about battery supply, and transmit the recommendation information to a computer on the supply side.

14. The battery residual value management system according to claim 2, wherein
the processor determines and outputs a guarantee service content of the battery according to a grade of the abnormal degradation level of the battery.

15. The battery residual value management system according to claim 2, wherein
the processor determines and outputs a degradation monitoring service content of the battery according to a grade of the abnormal degradation level of the battery.

16. The battery residual value management system according to claim 4, wherein
the index is an abnormal degradation level, and
the processor determines and outputs a guarantee service content of the battery and a degradation monitoring service content of the battery according to a grade of the abnormal degradation level determined based on the calibrated threshold value.

17. A battery residual value management method that manages a residual value of a battery, comprising:
causing at least one processor to acquire, from at least one storage device configured to store information about a multi-dimensional vector space, the information about the multi-dimensional vector space, the multi-dimensional vector space being formed by at least three indexes for evaluating the residual value of the battery, and including a plurality of regions for determining a residual value rank of the battery, each of the regions being a region defined by one or more threshold values set for each index in the multi-dimensional vector space; and
causing the processor to determine, based on the at least three indexes of the battery that is a residual value assessment target, to which of the plurality of regions in the multi-dimensional vector space the battery being the residual value assessment target belongs, thereby determining the residual value rank of the battery that is the residual value assessment target.

18. The battery residual value management method according to claim 17, wherein
the multi-dimensional vector space is formed by indexes including an SOH of the battery, internal-resistance-related information of the battery, and an abnormal degradation level of the battery.

19. The battery residual value management method according to claim 17, further comprising:
causing the processor to extract, from a plurality of batteries for which the residual value rank is determined, a battery matching a desired specification range received from outside, and output the extracted information.

20. The battery residual value management method according to claim 17, further comprising:
causing the processor to acquire, from outside, degradation information about the battery in an actual operating state;
causing the processor to construct, based on the degradation information, degradation tendency information about the battery in the actual operating state;
causing the processor to execute processing of calibrating the one or more threshold values of the index based on the degradation tendency information; and
causing the processor to determine, using the calibrated threshold value, the residual value rank of the battery that is the residual value assessment target.

21. The battery residual value management method according to claim 17, further comprising:
causing the processor to acquire, from outside, market price information about the battery corresponding to a value of the index;
causing the processor to execute processing of correcting the one or more threshold values of the index based on the market price information; and
causing the processor to determine, using the corrected threshold value, the residual value rank of the battery that is the residual value assessment target.

22. The battery residual value management method according to claim 19, further comprising:
causing the processor to acquire, from outside, battery reservation information including residual value data, a quantity, and a delivery date of a battery desired by a demand side; and
causing the processor to summarize the battery reservation information based on a type of the battery, and output the summarized battery reservation information as demand plan information.

23. The battery residual value management method according to claim 22, wherein
the processor classifies the battery reservation information into a short-term reservation, a medium-term reservation, and a long-term reservation according to timing of the delivery date, summarizes the battery reservation information for each classification, and outputs the summarized battery reservation information as the demand plan information.

24. The battery residual value management method according to claim 19, further comprising:
causing the processor to acquire, from outside, battery procurement information including residual value data, a quantity, and a delivery date of a battery available on a supply side; and
causing the processor to summarize the battery procurement information based on a type of the battery, and output the summarized battery procurement information as procurement plan information.

25. The battery residual value management method according to claim 24, wherein
the processor classifies the battery procurement information into a short-term procurement, a medium-term procurement, and a long-term procurement according to timing of the delivery date of the supply side, summarizes the battery procurement information for each classification, and outputs the summarized battery procurement information as the procurement plan information.

26. The battery residual value management method according to claim 22, further comprising:
causing the processor to acquire, from outside, battery procurement information including residual value data, a quantity, and a delivery date of a battery available on a supply side; and
causing the processor to summarize the battery procurement information based on a type of the battery and output the summarized battery procurement information as procurement plan information.

27. The battery residual value management method according to claim 26, further comprising:
causing the processor to match the demand plan information with the procurement plan information to determine a balance between demand and supply of each battery.

28. The battery residual value management method according to claim 27, further comprising:
causing the processor to generate, by executing machine learning on information indicating the balance between demand and supply of each battery, prediction information including future supply prediction and demand prediction; and
causing the processor to output the prediction information.

29. The battery residual value management method according to claim 28, further comprising:
causing the processor to generate, based on the prediction information, recommendation information about battery supply; and
causing the processor to transmit the recommendation information to a computer on the supply side.

30. The battery residual value management method according to claim 18, further comprising:
causing the processor to determine and output a guarantee service content of the battery according to a grade of the abnormal degradation level of the battery.

31. The battery residual value management method according to claim 18, further comprising:
causing the processor to determine and output a degradation monitoring service content of the battery according to a grade of the abnormal degradation level of the battery.

32. The battery residual value management method according to claim 20, wherein
the index is an abnormal degradation level, and
the battery residual value management method further comprises causing the processor to determine and output a guarantee service content of the battery and a degradation monitoring service content of the battery according to a grade of the abnormal degradation level determined based on the calibrated threshold value.
